# EUROPEAN PATENT APPLICATION

(11) **EP 4 517 805 A1**
(43) Date of publication of application: **05.03.2025**
(21) Application number: 24183028.0
(22) Date of filing: 19.06.2024
(51) Int. Cl.: H01L 21/8234, H01L 21/768, H01L 27/088, H01L 29/417, H01L 29/66, H01L 29/775, H01L 29/08, H01L 29/06

(54) **INTEGRATED CIRCUIT DEVICE AND METHOD OF MANUFACTURING THE SAME**

(30) Priority: 31.08.2023 KR 20230115603
(71) Applicant: Samsung Electronics Co., Ltd., Suwon-si, Gyeonggi-do 16677 (KR)
(72) Inventor: SHIN, Jongmin, 16677 Suwon-si, Gyeonggi-do (KR); JEONG, Woncheol, 16677 Suwon-si, Gyeonggi-do (KR); SHIN, Heonjong, 16677 Suwon-si, Gyeonggi-do (KR)
(74) Representative: Kuhnen & Wacker Patent- und Rechtsanwaltsbüro PartG mbB

(57) **Abstract**

An integrated circuit device includes a plurality of device isolation layers (114) extending lengthwise in a first horizontal direction (X), a plurality of gap-fill insulation layers (222) arranged apart from one another in a second horizontal direction (Y), a plurality of gate structures (162) extending lengthwise in the second horizontal direction (Y) perpendicular to the first horizontal direction (X) and on the plurality of gap-fill insulation layers (222), a first source/drain region (130a) and a second source/drain region (130b) respectively disposed at both sides of a first gate structure (162) among the plurality of gate structures (162) with respect to the first horizontal direction (X), an insulation block (212) under the first source/drain region (130a), and an insulation barrier (124) between the first source/drain region (130a) and the insulation block (212). The insulation barrier (124) covers a lower surface of the first source/drain region (130a).

## Description

### BACKGROUND

Inventive concepts relate to an integrated circuit device, and more particularly, to an integrated circuit device including a power rail.

As electronic technology advances, the down-scaling of integrated circuit devices has been rapidly done. Because semiconductor devices need the accuracy of an operation as well as a fast operation speed, various research for optimizing a structure of a transistor included in semiconductor devices is being done.

### SUMMARY

Inventive concepts provide an integrated circuit device in which the degree of integration and reliability are enhanced.

Inventive concepts provide a method of manufacturing an integrated circuit device in which the degree of integration and reliability are enhanced.

According to an embodiment of inventive concepts, an integrated circuit device may include a plurality of device isolation layers extending lengthwise in a first horizontal direction, the plurality of device isolation layers arranged apart from one another in a second horizontal direction, the second horizontal direction being perpendicular to the first horizontal direction; a plurality of gap-fill insulation layers arranged apart from one another in the first horizontal direction between adjacent device isolation layers among the plurality of device isolation layers; a plurality of gate structures arranged apart from one another in the first horizontal direction, the plurality of gate structures on the plurality of gap-fill insulation layers and extending lengthwise in the second horizontal direction; a first source/drain region and a second source/drain region respectively disposed at both sides of a first gate structure among the plurality of gate structures with respect to the first horizontal direction; an insulation block under the first source/drain region; an insulation barrier between the first source/drain region and the insulation block, the insulation barrier covering a lower surface of the first source/drain region; and a lower contact apart from the insulation block in the first horizontal direction with a first gap-fill insulation layer among the plurality of gap-fill insulation layers therebetween, the lower contact contacting a lower surface of the second source/drain region, and the lower contact being under the second source/drain region.

According to an embodiment of inventive concepts, an integrated circuit device may include a plurality of device isolation layers apart from one another in a second horizontal direction, the second horizontal direction being perpendicular to a first horizontal direction, the plurality of device isolation layers defining sidewalls of a backside trench extending lengthwise in the first horizontal direction between adjacent device isolation layers among the plurality of device isolation layers; a plurality of gap-fill insulation layers in the backside trench and arranged apart from one another in the first horizontal direction; a plurality of insulation barriers in the backside trench and respectively disposed between adjacent gap-fill insulation layers of the plurality of gap-fill insulation layers; a first source/drain region on a first insulation barrier of the plurality of insulation barriers; a second source/drain region on a second insulation barrier of the plurality of insulation barriers; a gate structure between the first source/drain region and the second source/drain region, the gate structure on a first gap-fill insulation layer of the plurality of gap-fill insulation layers; a first insulation block facing a lower surface of the first source/drain region in a vertical direction with the first insulation barrier therebetween; and a lower contact apart from the first insulation block in the first horizontal direction with the first gap-fill insulation layer therebetween, the lower contact passing through the second insulation barrier and contacting the second source/drain region.

According to an embodiment of inventive concepts, an integrated circuit device may include a plurality of device isolation layers extending lengthwise in a first horizontal direction, the plurality of device isolation layers arranged apart from one another in a second horizontal direction, the second horizontal direction being perpendicular to the first horizontal direction; a plurality of gap-fill insulation layers arranged apart from one another in the first horizontal direction between adjacent device isolation layers among the plurality of device isolation layers; a nanosheet structure a position apart in a vertical direction from an upper surface of a first gap-fill insulation layer among the plurality of gap-fill insulation layers and facing the upper surface of the first gap-fill insulation layer, the nanosheet structure including a nanosheet or a plurality of nanosheets spaced apart from each other in the vertical direction; a gate structure on the first gap-fill insulation layer, the gate structure extending lengthwise in the second horizontal direction and surrounding the nanosheet structure; a first source/drain region and a second source/drain region respectively disposed at both sides of the gate structure in the first horizontal direction; an insulation block under the first source/drain region; an insulation barrier between the first source/drain region and the insulation block in the vertical direction, a vertical level of an upper surface of the insulation barrier being higher than a lower surface of the gate structure; and a lower contact apart from the insulation block in the first horizontal direction with the first gap-fill insulation layer therebetween, the lower contact being under the second source/drain region.

### BRIEF DESCRIPTION OF THE DRAWINGS

Embodiments will be more clearly understood from the following detailed description taken in conjunction with the accompanying drawings in which:

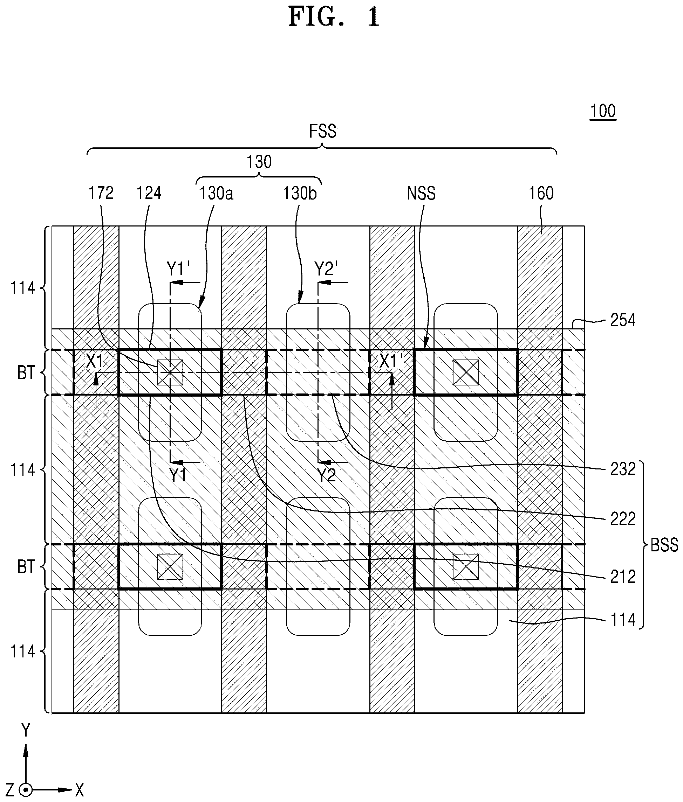

FIG. 1 is a plan layout diagram of some elements of an integrated circuit device according to embodiments;

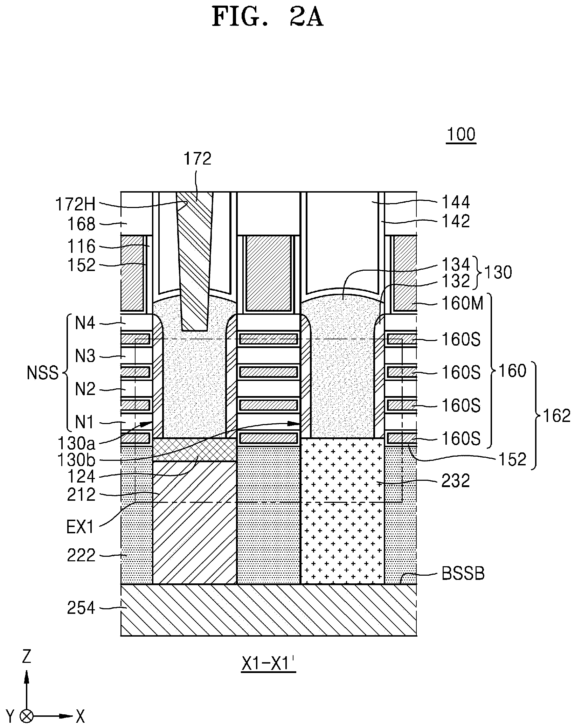

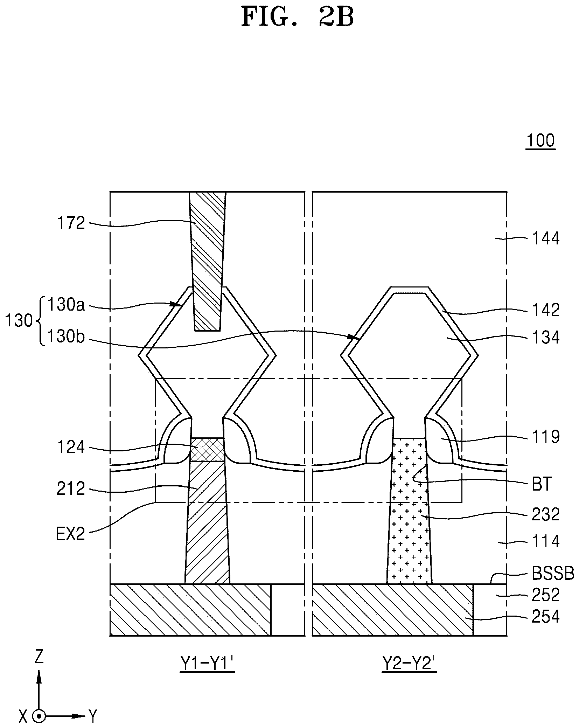

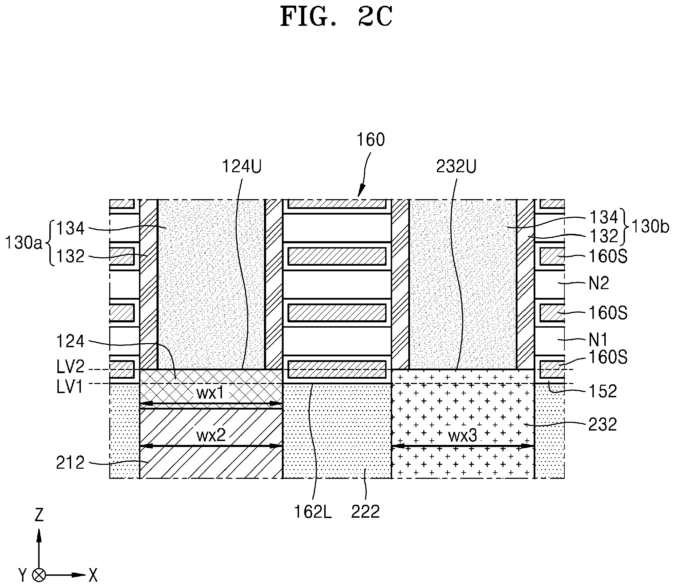

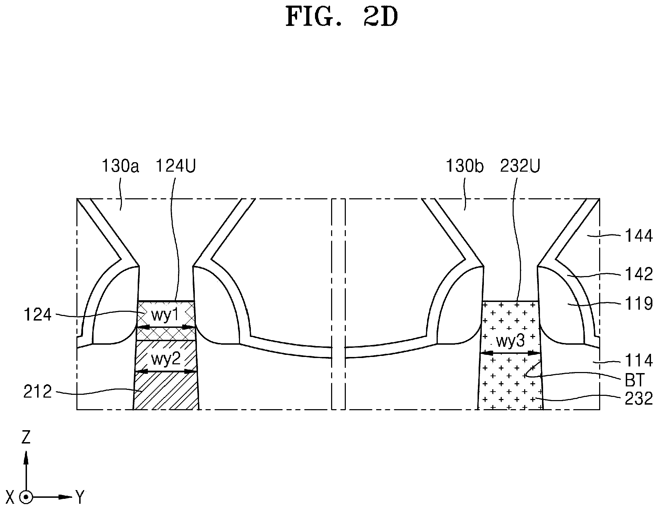

FIG. 2A is a cross-sectional view taken along line X1-X1' of FIG. 1, FIG. 2B is a cross-sectional view illustrating a cross-sectional surface taken along line Y1-Y1' of FIG. 1 and a cross-sectional surface taken along line Y2-Y2' of FIG. 1, FIG. 2C is an enlarged view of a region EX1 of FIG. 2A, and FIG. 2D is an enlarged view of a region EX2 of FIG. 2B;

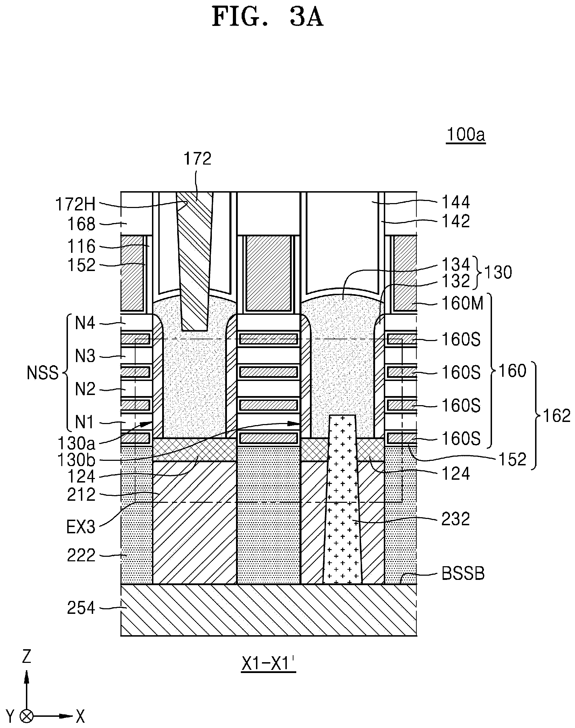

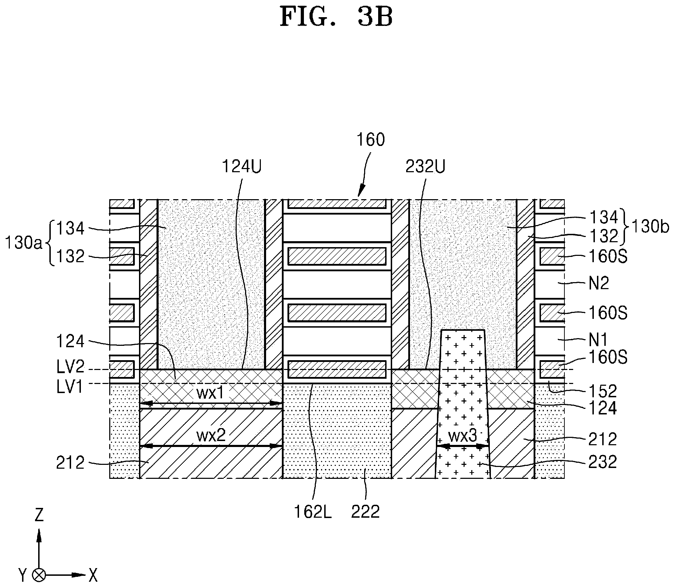

FIGS. 3A and 3B are cross-sectional views for describing an integrated circuit device according to some other embodiments, FIG. 3A is a cross-sectional view of a portion corresponding to a cross-sectional surface taken along line X1-X1' of FIG. 1, and FIG. 3B is an enlarged view of a region EX3 of FIG. 3A;

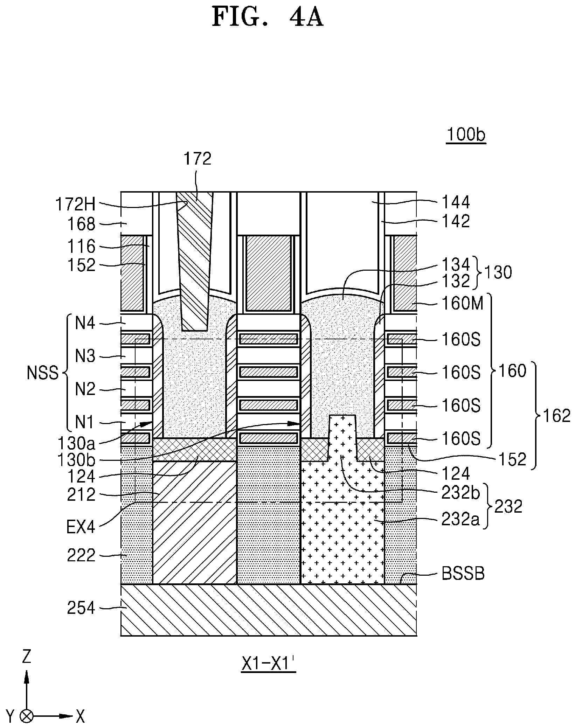

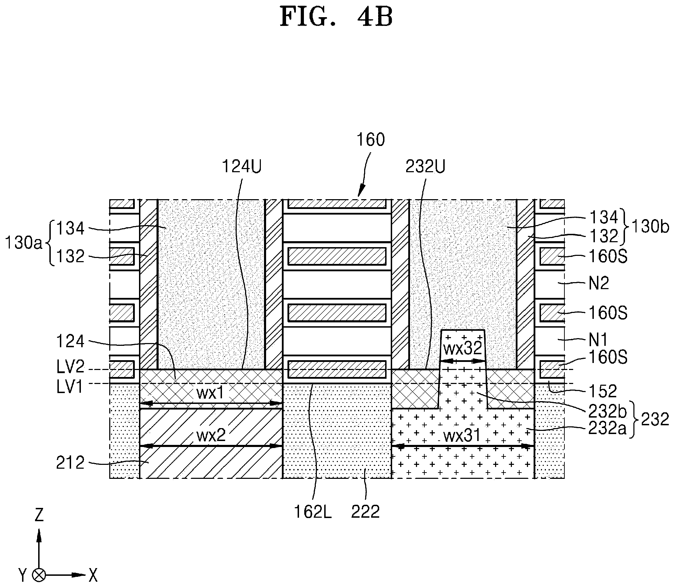

FIGS. 4A and 4B are cross-sectional views for describing an integrated circuit device according to some other embodiments; FIG. 4A is a cross-sectional view of a portion corresponding to a cross-sectional surface taken along line X1-X1' of FIG. 1, and FIG. 4B is an enlarged view of a region EX4 of FIG. 4A;

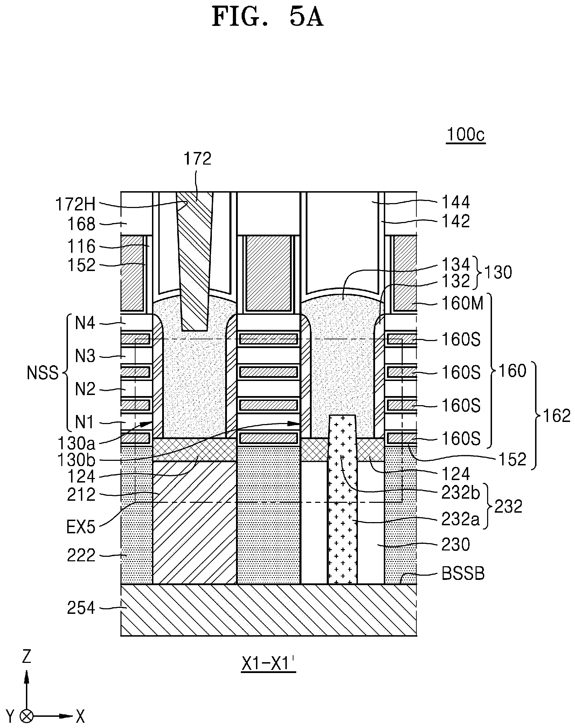

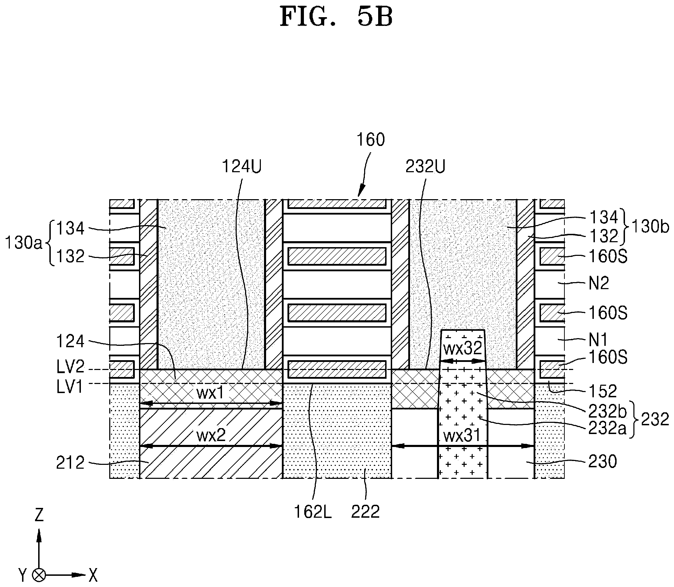

FIGS. 5A and 5B are cross-sectional views for describing an integrated circuit device according to some other embodiments; FIG. 5A is a cross-sectional view of a portion corresponding to a cross-sectional surface taken along line X1-X1' of FIG. 1, and FIG. 5B is an enlarged view of a region EX5 of FIG. 5A; and

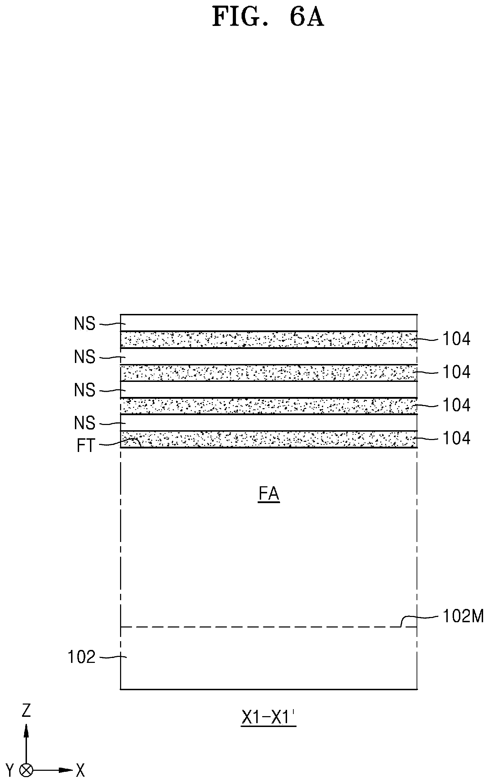

FIGS. 6A to 19B are cross-sectional views illustrating in a process sequence a method of manufacturing an integrated circuit device, according to embodiments, FIGS. 6A, 7A, 8A, 9A, 10A, 11A, 12, 13, 14A, 15A, 16A, 17A, 18A, and 19A are cross-sectional views illustrating in a process sequence a portion corresponding to a cross-sectional surface taken along line X1-X1' of FIG. 1, and FIGS. 6B, 7B, 8B, 9B, 10B, 11B, 14B, 15B, 16B, 17B, 18B, and 19B are cross-sectional views illustrating in a process sequence a cross-sectional surface taken along line Y1-Y1' of FIG. 1 and a cross-sectional surface taken along line Y2-Y2' of FIG. 1.

### DETAILED DESCRIPTION

While the term "equal to" is used in the description of example embodiments, it should be understood that some imprecisions may exist. Thus, when one element is referred to as "equal to" another element, it should be understood that an element or a value may be "equal to" another element within a desired manufacturing or operational tolerance range (e.g., ±10%).

Hereinafter, embodiments will be described in detail with reference to the accompanying drawings. Like reference numerals refer to like elements in the drawings, and their repeated descriptions are omitted.

Herein, a vertical direction may be defined as a Z direction, and a horizontal direction may be defined as a direction perpendicular to the Z direction. A first horizontal direction and a second horizontal direction may be defined as directions intersecting with each other. The first horizontal direction may be referred to as an X direction, and the second horizontal direction may be referred to as a Y direction. A vertical level may be referred to as a height level with respect to the vertical direction (the Z direction).

FIG. 1 is a plan layout diagram of some elements of an integrated circuit device 100 according to embodiments. FIG. 2A is a cross-sectional view taken along line X1-X1' of FIG. 1, FIG. 2B is a cross-sectional view illustrating a cross-sectional surface taken along line Y1-Y1' of FIG. 1 and a cross-sectional surface taken along line Y2-Y2' of FIG. 1, FIG. 2C is an enlarged view of a region EX1 of FIG. 2A, and FIG. 2D is an enlarged view of a region EX2 of FIG. 2B.

According to embodiments described below with reference to FIGS. 1 and 2A to 2D, the integrated circuit device 100 may configure a logic cell which includes an active region having a nanowire or nanosheet shape and a gate-all-around (GAA) type field effect transistor (FET) device including a gate surrounding the active region. For example, the integrated circuit device 100 may include a multi bridge channel (MBC) FET (MBCFET) device. However, inventive concepts are not limited thereto, and the integrated circuit device 100 may include a planar FET device and a finFET device.

Referring to FIGS. 1 and 2A to 2D, the integrated circuit device 100 may include a backside structure BSS and a front-side structure FSS on the backside structure BSS. According to embodiments, the backside structure BSS may include a plurality of device isolation layers 114, a plurality of gap-fill insulation layers 222, a plurality of insulation blocks 212, a plurality of lower contacts 232, and a backside power rail. According to embodiments, the front-side structure FSS may include a plurality of nanosheet stacks NSS, a plurality of gate electrodes 160, a plurality of source/drain regions 130, a plurality of insulation barriers 124, and a plurality of upper contacts 172.

According to embodiments, the plurality of device isolation layers 114 may extend long in a first horizontal direction (an X direction) and may be apart from each other in a second horizontal direction (a Y direction) perpendicular to the first horizontal direction (the X direction) with each of a plurality of backside trenches BT therebetween. For example, the plurality of device isolation layers 114 may extend in parallel in the first horizontal direction (the X direction). For example, the plurality of backside trenches BT may extend long in the first horizontal direction (the X direction) and may be defined by the plurality of device isolation layers 114.

In some embodiments, the device isolation layers 114 may include at least one material selected from among silicon oxide, silicon nitride, and silicon oxynitride.

According to embodiments, the plurality of gap-fill insulation layers 222 may be arranged apart from one another in the first horizontal direction (the X direction), in each of the plurality of backside trenches BT. The plurality of gap-fill insulation layers 222 may extend in the vertical direction (the Z direction) in the plurality of backside trenches BT. According to embodiments, both sidewalls of the plurality of gap-fill insulation layers 222 in the second horizontal direction (the Y direction) may contact the device isolation layer 114.

In some embodiments, the plurality of gap-fill insulation layers 222 may include silicon nitride (SiN), silicon oxide (SiO), SiCN, SiBN, SiON, SiOCN, SiBCN, SiOC, or a combination thereof, but the embodiments are not limited thereto. The terms "SiN", "SiO", "SiCN", "SiBN", "SiON", "SiOCN", "SiBCN", and "SiOC" used herein may each denote a material consisting of elements included in a corresponding term and may not be a chemical formula representing a stoichiometric relationship.

According to embodiments, an active structure may be disposed on each of the plurality of gap-fill insulation layers 222. For example, the active structure may have a fin shape, a nanowire shape, or a nanosheet shape. In FIGS. 2A to 2C, the active structure is illustrated as the nanosheet stack NSS but is not limited thereto.

According to embodiments, the plurality of nanosheet stacks NSS may be disposed on the plurality of gap-fill insulation layers, respectively. The nanosheet stacks NSS also may be referred to as nanosheet structures. According to embodiments, each of the plurality of nanosheet stacks NSS may include at least one nanosheet. According to embodiments, each of the plurality of nanosheet stacks NSS may be disposed at a position apart from an upper surface of a corresponding gap-fill insulation layer 222 of the plurality of gap-fill insulation layers 222 in the vertical direction (the Z direction).

Each of the plurality of nanosheet stacks NSS may include a plurality of nanosheets which are apart from one another in the vertical direction (the Z direction) and vertically overlap one another and for example, may include a first nanosheet N1, a second nanosheet N2, a third nanosheet N3, and a fourth nanosheet N4. The term "nanosheet" used herein may denote a conductive structure including a cross-sectional surface substantially perpendicular to a direction in which a current flows. The nanosheet has to be understood as including a nanowire. Also, herein, a plurality of nanosheets N1 to N4 or the nanosheet stack NSS may be referred to as a channel region.

The first nanosheet N1, the second nanosheet N2, the third nanosheet N3, and the fourth nanosheet N4 may differ in distance from an upper surface of the gap-fill insulation layer 222 with respect to the vertical direction (the Z direction). Each of the first nanosheet N1, the second nanosheet N2, the third nanosheet N3, and the fourth nanosheet N4 each included in the nanosheet stack NSS may include a channel region. For example, each of the first nanosheet N1, the second nanosheet N2, the third nanosheet N3, and the fourth nanosheet N4 may have a thickness selected within a range of about 4 nm to about 6 nm with respect to the vertical direction (the Z direction) but is not limited thereto. In some embodiments, the first nanosheet N1, the second nanosheet N2, and the third nanosheet N3 may have substantially the same thickness in the vertical direction (the Z direction). In some other embodiments, at least some of the first nanosheet N1, the second nanosheet N2, and the third nanosheet N3 may have different thicknesses in the vertical direction (the Z direction).

In some embodiments, at least some of the first nanosheet N1, the second nanosheet N2, the third nanosheet N3, and the fourth nanosheet N4 each included in one nanosheet stack NSS may have different thicknesses in the vertical direction (the Z direction). In some other embodiments, at least some of the first nanosheet N1, the second nanosheet N2, the third nanosheet N3, and the fourth nanosheet N4 may have the same thickness in the first horizontal direction (the X direction).

According to embodiments, a plurality of gate structures 162, which cross the plurality of device isolation layers 114 and extend long in the second horizontal direction (the Y direction), may be disposed on the plurality of device isolation layers 114. According to embodiments, the plurality of gap-fill insulation layers 222 may be respectively disposed in regions where the plurality of gate structures 162 intersect with the plurality of backside trenches BT, and the plurality of gate structures 162 may respectively cover the plurality of nanosheet stacks NSS and surround the plurality of nanosheets N1 to N4, on the plurality of gap-fill insulation layers 222. For example, nanosheet stacks NSS of a first group arranged in the second horizontal direction (the Y direction) among the plurality of nanosheet stacks NSS may be surrounded by a first gate structure 162 of the plurality of gate structures 162. According to embodiments, each of the plurality of gate structures 162 may include a portion which contacts and overlaps a corresponding nanosheet stack of the plurality of nanosheet stacks NSS.

According to embodiments, a plurality of transistors may be respectively formed at portions where the plurality of nanosheet stacks NSS respectively overlap the plurality of gate structures 162. According to embodiments, the plurality of transistors may include a PMOS transistor and an NMOS transistor. For example, each of the plurality of transistors may include at least one nanosheet stack NSS, a gate structure 162 surrounding the at least one nanosheet stack NSS, and source/drain regions 130 facing the at least one nanosheet stack NSS in the first horizontal direction (the X direction).

In some embodiments, each of the plurality of nanosheets N1 to N4 may include a silicon (Si) layer, which is not doped. In some other embodiments, each of the plurality of nanosheets N1 to N4 may include a doped Si layer. For example, when the plurality of nanosheets N1 to N4 configure a PMOS transistor, the plurality of nanosheets N1 to N4 may include a Si layer doped with a p-type dopant, and when the plurality of nanosheets N1 to N4 configure an NMOS transistor, the plurality of nanosheets N1 to N4 may include a Si layer doped with an n-type dopant. However, inventive concepts are not limited thereto. The p-type dopant may be selected from among boron (B) and gallium (Ga). The n-type dopant may be selected from among phosphorous (P), arsenic (As), and antimony (Sb).

According to embodiments, the plurality of gate structures 162 may surround the plurality of nanosheet stacks NSS and may extend in parallel in the second horizontal direction (the Y direction), on the plurality of gap-fill insulation layers 222. For example, the plurality of gate structures 162 may be apart from one another in the first horizontal direction (the X direction). According to embodiments, the plurality of gate structures 162 may each include a gate electrode 160 and a gate dielectric layer 152 disposed between the nanosheet stack NSS and the gate electrode 160.

According to embodiments, each of the plurality of gate electrodes 160 may include a main gate portion 160M and a plurality of sub gate portions 160S. The main gate portion 160M may cover an upper surface of the nanosheet stack NSS and may extend in the second horizontal direction (the Y direction). The plurality of sub gate portions 160S may be connected with the main gate portion 160M as one body, and each of the plurality of sub gate portions 160S may be disposed between two adjacent nanosheets of the first nanosheet N1, the second nanosheet N2, the third nanosheet N3, and the fourth nanosheet N4 and between the first nanosheet N1 and the gap-fill insulation layer 222. With respect to the vertical direction (the Z direction), a thickness of each of the plurality of sub gate portions 160S may be less than that of the main gate portion 160M.

In some embodiments, each of the plurality of gate electrodes 160 may include metal, metal nitride, metal carbide, or a combination thereof. The metal may be selected from among titanium (Ti), tungsten (W), ruthenium (Ru), niobium (Nb), molybdenum (Mo), hafnium (Hf), nickel (Ni), cobalt (Co), platinum (Pt), ytterbium (Yb), terbium (Tb), dysprosium (Dy), erbium (Er), and palladium (Pd). The metal nitride may be selected from among TiN and TaN. The metal carbide may be TiAlC. However, a material configuring the plurality gate electrodes 160 is not limited thereto.

In some embodiments, the gate dielectric layer 152 may include a stack structure of an interface dielectric layer and a high-k dielectric layer. The interface dielectric layer may include a low-k dielectric layer having a dielectric constant of about 9 or less and for example, may include silicon oxide, silicon oxynitride, or a combination thereof. In some other embodiments, the interface dielectric layer may be omitted. The high-k dielectric layer may include a material having a dielectric constant which is greater than that of silicon oxide. For example, the high-k dielectric layer may have a dielectric constant of about 10 to about 25. The high-k dielectric layer may include Hf oxide but is not limited thereto.

According to embodiments, upper surfaces of the plurality of gate structures 162 may be covered by a capping insulation pattern 168. For example, each of the gate electrode 160 and the gate dielectric layer 152 may be covered by the capping insulation pattern 168. In some embodiments, the capping insulation pattern 168 may include silicon nitride.

According to embodiments, both sidewalls of each of the gate structure 162 and the capping insulation pattern 168 may be covered by an outer insulation spacer 116. The outer insulation spacer 116 may cover both sidewalls of the main gate portion 160M, on upper surfaces of the plurality of nanosheet stacks NSS. The outer insulation spacer 116 may be apart from the gate electrode 160 with the gate dielectric layer 152 therebetween.

According to embodiments, the plurality of source/drain regions 130 may be alternately arranged in the first horizontal direction (the X direction) and the second horizontal direction (the Y direction) between the plurality of gate structures 162. According to embodiments, the plurality of source/drain regions 130 may be apart from each other in the first horizontal direction (the X direction) with the plurality of nanosheet stacks NSS therebetween. For example, the plurality of source/drain regions 130 and the plurality of nanosheet stacks NSS may be alternately arranged in the first horizontal direction (the X direction). According to embodiments, two source/drain regions 130 adjacent to each other in the second horizontal direction (the Y direction) may be apart from each other in the second horizontal direction (the Y direction) with the inter-gate insulation layer 144 described below therebetween. In some embodiments, each of the plurality of source/drain regions 130 may fill a portion of a corresponding backside trench BT of the plurality of backside trenches BT.

According to embodiments, both sidewalls of each of the plurality of nanosheet stacks NSS in the first horizontal direction (the X direction) may face a corresponding source/drain region 130. According to embodiments, the plurality of source/drain regions 130 may face a sub gate portion 160S of the gate electrode 160 and the plurality of nanosheets N1 to N4 disposed adjacent thereto, in the first horizontal direction (the X direction). For example, both sidewalls of each of the plurality of source/drain regions 130 in the first horizontal direction (the X direction) may contact a portion of one gate structure 162 and one nanosheet stack NSS.

According to embodiments, each of the plurality of source/drain regions 130 may include a pair of source/drain barriers 132 and a source/drain body 134 between the pair of source/drain barriers 132. According to embodiments, the pair of source/drain barriers 132 may cover the sub gate portion 160S of the gate electrode 160 and the plurality of nanosheets N1 to N4 disposed adjacent thereto, at both sides thereof in the first horizontal direction (the X direction). For example, the pair of source/drain barriers 132 may contact one side surface of each of the plurality of nanosheets N1 to N4 and may face the sub gate portion 160S of the gate electrode 160 with the gate dielectric layer 152 therebetween. According to embodiments, the source/drain body 134 may be apart from the plurality of nanosheets N1 to N4 and the sub gate portion 160S with a corresponding source/drain barrier 132 therebetween, at both sides thereof in the first horizontal direction (the X direction).

In some embodiments, the pair of source/drain barriers 132 may be apart from each other in the first horizontal direction (the X direction) with the source/drain body 134 therebetween. In some embodiments, each source/drain barrier 132 may be disposed between the source/drain body 134 and the plurality of nanosheets N1 to N4 and may extend in the vertical direction (the Z direction). In some embodiments, the pair of source/drain barriers 132 may include a material which is different from or the same as that of the source/drain body 134 but may have different composition rations.

In some embodiments, a first group including some of the plurality of source/drain regions 130 may configure a PMOS transistor. In some embodiments, source/drain barriers 132 and source/drain bodies 134 of the source/drain regions 130 of the first group may each include a Si₁₋ₓGeₓ layer (where 0.0 < x ≤ 0.6) doped with a p-type dopant, and a germanium (Ge) content ratio of the source/drain body 134 may be higher than a Ge content ratio in the source/drain barrier 132. In some embodiments, a Ge content ratio of the source/drain barrier 132 may be lower than or equal to about 0.0 at.% and for example, may be about 15 at.% or more and about 30 at.% or less. A Ge content ratio of the source/drain body 134 may be about 30 at.% or more and about 60 at.% or less and for example, may be about 40 at.% or more and about 30 at.% or less. However, inventive concepts are not limited to the descriptions above. In some embodiments, the p-type dopant may be at least one material selected from among boron (B) and gallium (Ga) but is not limited thereto. In some embodiments, the source/drain regions 130 of the first group may further include a first semiconductor capping layer (not shown), which covers an upper surface of the source/drain body 134. The first semiconductor capping layer (not shown) may include a SiGe layer having a Ge content ratio which is lower than that of an undoped Si layer, a Si layer doped with the p-type dopant, or the source/drain body 134.

In some other embodiments, a second group including some of the plurality of source/drain regions 130 may configure an NMOS transistor. The source/drain barriers 132 of the source/drain regions 130 of the second group may each include a Si layer, and the source/drain body 134 may include a Si layer doped with the n-type dopant. In some other embodiments, the source/drain barriers 132 and the source/drain bodies 134 may each include a Si layer doped with the n-type dopant, and a content ratio of n-type dopant of the source/drain body 134 may be higher than a content ratio of n-type dopant of the source/drain barrier 132. The n-type dopant may be selected from among P, As, and Sb but is not limited thereto. In some embodiments, the source/drain regions 130 of the second group may further include a second semiconductor capping layer (not shown), which covers an upper surface of the source/drain body 134. The second semiconductor capping layer (not shown) may include an undoped Si layer or a Si layer doped with the n-type dopant. When the second semiconductor capping layer (not shown) includes the Si layer doped with the n-type dopant, a content ratio of n-type dopant of the second semiconductor capping layer (not shown) may be lower than a content ratio of n-type dopant of the source/drain barrier 132.

As illustrated in FIG. 2B, a trench-side insulation spacer 119 covering a lower portion of a sidewall of each of the plurality of source/drain regions 130 in the second horizontal direction (the Y direction) may be disposed on the plurality of device isolation layers 114. For example, the trench-side insulation spacer 119 may contact a lower sidewall of each of the plurality of source/drain regions 130.

In some embodiments, a vertical level of an uppermost portion of the trench-side insulation spacer 119 may be higher than a vertical level of a lowermost surface of each of the plurality of source/drain regions 130. In some embodiments, the trench-side insulation spacer 119 may define the plurality of backside trenches BT along with the plurality of device isolation layers 114.

In some embodiments, the trench-side insulation spacer 119 may include SiN, SiO, SiCN, SiBN, SiON, SiOCN, SiBCN, SiOC, or a combination thereof. The terms "SiN", "SiO", "SiCN", "SiBN", "SiON", "SiOCN", "SiBCN", and "SiOC" used herein may each denote a material consisting of elements included in a corresponding term and may not be a chemical formula representing a stoichiometric relationship.

According to embodiments, the plurality of device isolation layers 114, the plurality of source/drain regions 130, the trench-side insulation spacer 119, and the outer insulation spacer 116 may be covered by an insulation liner 142. According to embodiments, an inter-gate insulation layer 144 may be disposed on the insulation liner 142. According to embodiments, the insulation liner 142 and the inter-gate insulation layer 144 may be disposed between two source/drain regions 130 adjacent to each other in the second horizontal direction (the Y direction).

In some other embodiments, the insulation liner 142 may be omitted. In this case, the inter-gate insulation layer 144 may contact the plurality of source/drain regions 130.

In some other embodiments, the insulation liner 142 may include SiN, SiCN, SiBN, SiON, SiOCN, SiBCN, SiOC, SiO₂, or a combination thereof. In some embodiments, the inter-gate insulation layer 144 may include silicon nitride, silicon oxide, SiON, SiOCN, or a combination thereof.

According to embodiments, the plurality of source/drain regions 130 may include a plurality of first source/drain regions 130a and a plurality of second source/drain regions 130b. According to embodiments, the plurality of first source/drain regions 130a and the plurality of second source/drain regions 130b may be apart from one another in the first horizontal direction (the X direction) with one nanosheet stack NSS therebetween. For example, the first source/drain regions 130a may each function as a drain region and the plurality of second source/drain regions 130b may each function as a source region. In FIG. 1, it is illustrated that the plurality of first source/drain regions 130a are arranged in one row in the second horizontal direction (the Y direction) and the plurality of second source/drain regions 130b are apart from the plurality of first source/drain regions 130a with one gate structure 162 therebetween and are arranged in one row in the second horizontal direction (the Y direction), but inventive concepts are not limited thereto. For example, at least one first source/drain region 130a and at least one second source/drain region 130b may be arranged in the second horizontal direction (the Y direction) between two adjacent gate structures 162. In some embodiments, the plurality of first source/drain regions 130a and the plurality of second source/drain regions 130b may have the same shape as illustrated in FIGS. 2A and 2B. In some other embodiments, the plurality of first source/drain regions 130a and the plurality of second source/drain regions 130b may have different shapes and for example, may have different horizontal widths or different vertical thicknesses.

According to embodiments, the integrated circuit device 100 may further include a plurality of upper contacts 172 on the plurality of first source/drain regions 130a. Each of the plurality of upper contacts 172 may extend long in the vertical direction (the Z direction) between a pair of gate structures 162 adjacent to each other among the plurality of gate structures 162. A metal silicide layer (not shown) may be disposed between the first source/drain region 130a and the upper contact 172.

Each of the plurality of upper contacts 172 may fill an inner portion of an upper contact hole 172H, which passes through the inter-gate insulation layer 144 and the insulation liner 142 in the vertical direction (the Z direction) and extends up to each of the plurality of first source/drain regions 130a. In some embodiments, the plurality of upper contacts 172 may electrically connect the plurality of first source/drain regions 130a with a wiring (not shown) on the plurality of upper contacts 172. Each of the plurality of first source/drain regions 130a may be apart from the upper contact 172 with the metal silicide layer (not shown) therebetween. Each of the plurality of first source/drain regions 130a may surround a lower portion of a corresponding upper contact 172 of the plurality of upper contacts 172 at an outer portion of each upper contact hole 172H.

In some embodiments, the metal silicide layer (not shown) may include titanium silicide but is not limited thereto. In some other embodiments, the metal silicide layer (not shown) may be omitted. In some embodiments, each of the plurality of upper contacts 172 may include metal, conductive metal nitride, or a combination thereof. For example, each of the plurality of upper contacts 172 may include tungsten (W), copper (Cu), aluminum (Al), titanium (Ti), tantalum (Ta), TiN, TaN, or an alloy thereof or a combination thereof.

According to embodiments, each of a plurality of insulation blocks 212 may be disposed on a lower surface of a corresponding first source/drain region 130a of the plurality of first source/drain regions 130a. For example, the plurality of insulation blocks 212 may overlap the plurality of first source/drain regions 130a in the vertical direction (the Z direction). According to embodiments, the plurality of insulation blocks 212 may extend in the vertical direction (the Z direction) in the plurality of backside trenches BT, both sidewalls of each of the plurality of insulation blocks 212 in the first horizontal direction (the X direction) may face and contact the gap-fill insulation layer 222, and both sidewalls of each of the plurality of insulation blocks 212 in the second horizontal direction (the Y direction) may face and contact the device isolation layer 114.

According to embodiments, a plurality of insulation barriers 124 may each be disposed between the plurality of first source/drain regions 130a and the plurality of insulation blocks 212. The plurality of insulation barriers 124 may cover lower surfaces of the plurality of first source/drain regions 130a, in the plurality of backside trenches BT. For example, the lower surface of each of the plurality of first source/drain regions 130a may face an upper surface of a corresponding insulation block 212 of the plurality of insulation blocks 212 with the insulation barrier 124 therebetween.

According to embodiments, an upper surface 124U of each of the plurality of insulation barriers 124 may contact lower surfaces of a pair of source/drain barriers 132 and a lower surface of one source/drain body 134. According to embodiments, a pair of source/drain barriers 132 and source/drain bodies 134 of each of the plurality of first source/drain regions 130a may be apart from the insulation block 212 and the plurality of gap-fill insulation layers 222 with the insulation barrier 124 therebetween. For example, the plurality of gap-fill insulation layers 222 may include a sidewall which faces the plurality of insulation barriers 124 and/or the plurality of insulation blocks 212 and may entirely cover a lower surface 162L of the gate structure 162.

Referring to FIGS. 2C and 2D, the lower surface 162L of each of the plurality of gate structures 162 may be disposed at a first vertical level LV1. For example, a gate dielectric layer 152 covering a lower surface of an lowermost portion of each of the plurality of gate electrodes 160 may be disposed at a first vertical level LV1. According to embodiments, an upper surface 124U of each of the plurality of insulation barriers 124 may be disposed at a second vertical level LV2, which is higher than the first vertical level LV1. In some embodiments, the upper surface 124U of each of the plurality of insulation barriers 124 may be disposed at a vertical level which is higher than a lower surface of a lowermost end portion of the sub gate portion 160S of each of the plurality of gate electrodes 160. For example, an upper surface of each of the plurality of gap-fill insulation layers 222 may contact the lower surface 162L of each of the plurality of gate structures 162 and may be disposed at a vertical level which is lower than the upper surface 124U of each of the plurality of insulation barriers 124.

According to embodiments, both sidewalls of each of the plurality of insulation barriers 124 in the first horizontal direction (the X direction) may each include a portion facing the gate structure 162. In some embodiments, both sidewalls of each of the plurality of insulation barriers 124 in the first horizontal direction (the X direction) may be apart from a lowermost sub gate portion 160S of the gate electrode 160 with the gate dielectric layer 152 therebetween.

In some embodiments, a lower surface of each of the plurality of insulation barriers 124 may be disposed at a vertical level which is lower than the first vertical level LV1. In this case, both sidewalls of each of the plurality of insulation barriers 124 in the first horizontal direction (the X direction) may include a portion which contacts and faces the plurality of gap-fill insulation layers 222. In some other embodiments, the lower surface of each of the plurality of insulation barriers 124 may be disposed at a vertical level which is higher than or equal to the first vertical level LV1. In this case, a sidewall of each of the plurality of insulation blocks 212 may include a portion which faces the plurality of gate structures 162.

In some embodiments, both sidewalls of each of the plurality of insulation barriers 124 in the second horizontal direction (the Y direction) may include a portion which contacts the trench-side insulation spacer 119 and a portion which contacts the device isolation layer 114.

In some embodiments, the plurality of insulation barriers 124 and the plurality of insulation blocks 212 may each include SiN, SiO, SiCN, SiBN, SiON, SiOCN, SiBCN, SiOC, or a combination thereof. The terms "SiCN", "SiBN", "SiON", "SiOCN", "SiBCN", and "SiOC" used herein may each denote a material consisting of elements included in a corresponding term and may not be a chemical formula representing a stoichiometric relationship.

In some embodiments, the plurality of insulation barriers 124 may include a material which differs from that of the plurality of gap-fill insulation layers 222. In some embodiments, the plurality of insulation blocks 212 may include a material which differs from that of the plurality of gap-fill insulation layers 222.

According to embodiments, the plurality of insulation barriers 124 of the integrated circuit device 100 may cover a lower surface of each of the plurality of first source/drain regions 130a so as not to be exposed. The plurality of insulation barriers 124 may protect the plurality of first source/drain regions 130a so as not to be etched in a manufacturing process of the integrated circuit device 100, or may limit and/or prevent a leakage current from occurring when a peripheral semiconductor material remaining without being removed contacts the plurality of first source/drain regions 130a. For example, the plurality of insulation barriers 124 may be disposed between the plurality of first source/drain regions 130a and the plurality of gap-fill insulation layers 222, and the plurality of gap-fill insulation layers 222 may entirely contact the lower surface 162L of the gate structure 162 and may be apart from the first source/drain region 130a. Therefore, power loss caused by the integrated circuit device 100 may be limited and/or prevented, and thus, electrical reliability may be enhanced.

According to embodiments, each of a plurality of lower contacts 232, which fills a portion of a corresponding backside trench BT of the plurality of backside trenches BT and extends in the vertical direction (the Z direction), may be disposed on a lower surface of a corresponding second source/drain region 130b of the plurality of second source/drain regions 130b. For example, each of the plurality of lower contacts 232 may vertically overlap a corresponding second source/drain region 130b of the plurality of second source/drain regions 130b and may contact the corresponding second source/drain region 130b of the plurality of second source/drain regions 130b. According to embodiments, an upper surface 232U of each of the plurality of lower contacts 232 may contact lower surfaces of a pair of source/drain barriers 132 and a lower surface of one source/drain body 134.

According to embodiments, both sidewalls of each of the plurality of lower contacts 232 in the first horizontal direction (the X direction) may include a portion which faces and contacts the gap-fill insulation layer 222, and both sidewalls of each of the plurality of lower contacts 232 in the second horizontal direction (the Y direction) may include a portion which faces and contacts the device isolation layer 114. According to embodiments, the plurality of gap-fill insulation layers 222 may be disposed between the plurality of insulation blocks 212 and the plurality of lower contacts 232 in the first horizontal direction (the X direction).

Unlike the illustration of FIG. 1, in a case where two first source/drain regions 130a are arranged adjacent to each other in the first horizontal direction (the X direction) with the gate structure 162 therebetween, two insulation blocks 212 respectively disposed under the two first source/drain regions 130a may be apart from each other in the first horizontal direction (the X direction) with the gap-fill insulation layer 222 therebetween. Likewise, unlike the illustration of FIG. 1, in a case where two second source/drain regions 130b are arranged adjacent to each other in the first horizontal direction (the X direction) with the gate structure 162 therebetween, two lower contacts 232 respectively disposed under the two second source/drain regions 130b may be apart from each other in the first horizontal direction (the X direction) with the gap-fill insulation layer 222 therebetween. For example, in each backside trench BT, each of the plurality of insulation blocks 212 and a corresponding lower contact 232 of the plurality of lower contacts 232 may be apart from each other with the gap-fill insulation layer 222 therebetween and may be arranged in the first horizontal direction (the X direction).

According to embodiments, an upper surface 232U of each of the plurality of lower contacts 232 may be disposed at the second vertical level LV2, which is the same vertical level as the upper surface 124U of each of the plurality of insulation barriers 124. According to embodiments, the upper surface 232U of each of the plurality of lower contacts 232 may be disposed at a vertical level which is higher than the lower surface 162L of each of the plurality of gate structures 162. In this case, both sidewalls of each of the plurality of lower contacts 232 in the first horizontal direction (the X direction) may include a portion which faces the plurality of gate structures 162. For example, both sidewalls of each of the plurality of lower contacts 232 in the first horizontal direction (the X direction) may include a portion facing the lowermost sub gate portion 160S of the gate electrode 160 with the gate dielectric layer 152 therebetween. In some embodiments, both sidewalls of each of the plurality of lower contacts 232 in the second horizontal direction (the Y direction) may include a portion which contacts and faces the trench-side insulation spacer 119.

In some embodiments, the plurality of second source/drain regions 130b may include a flat bottom profile, and the plurality of lower contacts 232 may entirely cover lower surfaces of the plurality of second source/drain regions 130b. For example, the plurality of lower contacts 232 may contact the plurality of second source/drain regions 130b, or may not pass through the plurality of second source/drain regions 130b and extend to an inner portion thereof.

In some embodiments, the plurality of lower contacts 232 may include a conductive material. The conductive material may include, for example, doped polysilicon or metal, but the embodiments are not limited thereto. In some embodiments, the plurality of lower contacts 232 may include a metal body extending in the vertical direction (the Z direction) and a conductive barrier layer surrounding the metal body. The metal body may include Ru, Co, W, or a combination thereof. The conductive barrier layer may include Ti, TiN, Ta, TaN, or a combination thereof.

In FIGS. 2A to 2D, it is illustrated that the upper surfaces 124U of the plurality of insulation barriers 124, the upper surfaces 232U of the plurality of lower contacts 232, and the upper surfaces of the plurality of insulation blocks 212 each have flat shape, but the embodiments are not limited thereto. For example, each of the upper surfaces 124U of the plurality of insulation barriers 124, the upper surfaces 232U of the plurality of lower contacts 232, and the upper surfaces of the plurality of insulation blocks 212 may independently have an upward convex shape or a downward convex shape.

According to embodiments, the lower surface of each of the plurality of gap-fill insulation layers 222, the lower surface of a corresponding insulation block 212 of the plurality of insulation blocks 212, the lower surface of a corresponding lower contact 232 of the plurality of lower contacts 232, and the lower surface of a corresponding device isolation layer 114 of the plurality of device isolation layers 114 may configure a first coplanar surface BSSB.

According to embodiments, with respect to the first horizontal direction (the X direction), the plurality of insulation barriers 124 may have a first horizontal width wx1, the plurality of insulation blocks 212 may have a second horizontal width wx2, and the plurality of lower contacts 232 may have a third horizontal width wx3. In some embodiments, the first horizontal width wx1 may be the same as the second horizontal width wx2. For example, a sidewall of each of the plurality of insulation barriers 124 and a sidewall of a corresponding insulation block 212 of the plurality of insulation blocks 212 may configure a coplanar surface. In some embodiments, the third horizontal width wx3 may be the same as the first horizontal width wx1 and the second horizontal width wx2. In some other embodiments, each of the first horizontal width wx1, the second horizontal width wx2, and the third horizontal width wx3 may narrow progressively toward the first coplanar surface BSSB in the vertical direction (the Z direction). In this case, the first horizontal width wx1 may be greater than the second horizontal width wx2. In some embodiments, with respect to the same vertical level, the first horizontal width wx1 of the plurality of insulation barriers 124 may be the same as the third horizontal width wx3 of the plurality of lower contacts 232. In some embodiments, with respect to the same vertical level, the second horizontal width wx2 of the plurality of insulation blocks 212 may be the same as the third horizontal width wx3 of the plurality of lower contacts 232.

According to embodiments, with respect to the second horizontal direction (the Y direction), the plurality of insulation barriers 124 may have a fourth horizontal width wy1, the plurality of insulation blocks 212 may have a fifth horizontal width wy2, and the plurality of lower contacts 232 may have a sixth horizontal width wy3. In some embodiments, a width of each of the plurality of backside trenches BT in the second horizontal direction (the Y direction) may increase progressively in a direction distancing from the lower surface of a corresponding source/drain region 130 of the plurality of source/drain regions 130 toward the first coplanar surface BSSB in the vertical direction (the Z direction). In some embodiments, each of the fourth horizontal width wy1, the fifth horizontal width wy2, and the sixth horizontal width wy3 may increase progressively toward the first coplanar surface BSSB. For example, the plurality of insulation blocks 212 may be disposed at a vertical level which is lower than the plurality of insulation barriers 124, in the backside trench BT, and the fifth horizontal width wy2 may be greater than the fourth horizontal width wy1. In some embodiments, with respect to the same vertical level, the fourth horizontal width wy1 of the plurality of insulation barriers 124 may be the same as the sixth horizontal width wy3 of the plurality of lower contacts 232. In some embodiments, with respect to the same vertical level, the fifth horizontal width wy2 of the plurality of insulation blocks 212 may be the same as the sixth horizontal width wy3 of the plurality of lower contacts 232.

According to embodiments, the integrated circuit device 100 may include a metal power rail 254 extending in the first horizontal direction (the X direction), in a partial region of the first coplanar surface BSSB. According to embodiments, the metal power rail 254 may be configured to contact the lower surface of each of the plurality of lower contacts 232 and apply a voltage to the plurality of second source/drain regions 130b. The metal power rail 254 may be surrounded by the lower insulation layer 252 covering another region of the first coplanar surface BSSB.

In some embodiments, a plurality of metal power rails 254 may include a metal wiring layer and a conductive barrier layer surrounding the metal wiring layer. Detailed configurations of the metal wiring layer and the conductive barrier layer each configuring the metal power rail 254 may be substantially the same as the metal body and the conductive barrier layer each configuring the lower contact 232. In some embodiments, the lower insulation layer 252 may include silicon oxide, silicon nitride, silicon carbide, a low-k dielectric material, or a combination thereof.

FIGS. 3A and 3B are cross-sectional views for describing an integrated circuit device 100a according to some other embodiments, FIG. 3A is a cross-sectional view of a portion corresponding to a cross-sectional surface taken along line X1-X1' of FIG. 1, and FIG. 3B is an enlarged view of a region EX3 of FIG. 3A. In FIGS. 3A and 3B, the same reference numerals as FIGS. 1 and 2A to 2D refer to like elements, and repeated descriptions thereof are omitted.

According to embodiments, an insulation barrier 124 and an insulation block 212 may be sequentially arranged one-by-one on a lower surface of each of a plurality of source/drain regions 130. According to embodiments, one insulation barrier 124 and one insulation block 212 may configure one insulation structure, and the insulation structure may extend in a vertical direction (a Z direction) on a lower surface of each of the plurality of source/drain regions 130. According to embodiments, a plurality of gap-fill insulation layers 222 may be arranged apart from one another in a first horizontal direction (an X direction) with one insulation structure therebetween, in each backside trench BT.

For example, a first group including some of a plurality of insulation barriers 124 may cover lower surfaces of a plurality of first source/drain regions 130a, and a first group including some of a plurality of insulation blocks 212 may extend in the vertical direction (the Z direction) under the lower surfaces of the plurality of first source/drain regions 130a. For example, a second group including some of the plurality of insulation barriers 124 may cover lower surfaces of a plurality of second source/drain regions 130b, and a second group including some of the plurality of insulation blocks 212 may extend in the vertical direction (the Z direction) under the lower surfaces of the plurality of second source/drain regions 130b.

In some embodiments, the plurality of lower contacts 232 may pass through the insulation blocks 212 of the second group and the insulation barriers 124 of the second group in the vertical direction (the Z direction) and may contact the lower surfaces of the plurality of second source/drain regions 130b. For example, a portion of each of the plurality of lower contacts 232 may extend to an inner portion of a corresponding second source/drain region 130b of the plurality of second source/drain regions 130b. In some embodiments, upper surfaces of the plurality of lower contacts 232 may be disposed at a vertical level which is higher than the lower surfaces of the plurality of source/drain regions 130. For example, the upper surfaces of the plurality of lower contacts 232 may be disposed at a vertical level which is higher than a second vertical level LV2.

In some embodiments, a metal silicide layer (not shown) may be disposed between the plurality of second source/drain regions 130b and the plurality of lower contacts 232. Each of the plurality of second source/drain regions 130b may be apart from the lower contact 232 with the metal silicide layer (not shown) therebetween.

In some embodiments, a width of each of the plurality of lower contacts 232 in the first horizontal direction (the X direction) may narrow progressively in a direction distancing from a first coplanar surface BSSB in the vertical direction (the Z direction). For example, a width of an upper portion of each of the plurality of lower contacts 232 in the first horizontal direction (the X direction) may be narrower than a width of a lower portion of each of the plurality of lower contacts 232 in the first horizontal direction (the X direction). For example, a third horizontal width wx3 of the plurality of lower contacts 232 may increase progressively toward the first coplanar surface BSSB.

In some embodiments, the third horizontal width wx3 of the plurality of lower contacts 232 may be narrower than a first horizontal width wx1 of the plurality of insulation barriers 124 and may be narrower than a second horizontal width wx2 of the plurality of insulation blocks 212. In some embodiments, the plurality of lower contacts 232 may be apart from the plurality of gap-fill insulation layers 222 with the plurality of insulation barriers 124 and the plurality of insulation blocks 212 therebetween. In some embodiments, the plurality of lower contacts 232 may be apart from the plurality of gate structures 162 with the insulation barriers 124 of the second group therebetween.

FIGS. 4A and 4B are cross-sectional views for describing an integrated circuit device 100b according to some other embodiments. FIG. 4A is a cross-sectional view of a portion corresponding to a cross-sectional surface taken along line X1-X1' of FIG. 1, and FIG. 4B is an enlarged view of a region EX4 of FIG. 4A. In FIGS. 4A and 4B, the same reference numerals as FIGS. 1 and 2A to 2D refer to like elements, and repeated descriptions thereof are omitted.

According to embodiments, a plurality of insulation barriers 124 may cover lower surfaces of a plurality of source/drain regions 130. According to embodiments, a first group including some of the plurality of insulation barriers 124 may cover lower surfaces of a plurality of first source/drain regions 130a, and a second group including some of the plurality of insulation barriers 124 may cover lower surfaces of a plurality of second source/drain regions 130b.

According to embodiments, each of a plurality of lower contacts 232 may include a first portion 232a, which extends in a vertical direction (a Z direction) between two gap-fill insulation layers 222 adjacent to each other in a first horizontal direction (an X direction), and a second portion 232b which extends from the first portion 232a, passes through the insulation barriers 124 of the second group in the vertical direction (the Z direction), and contacts a corresponding second source/drain region 130b of the plurality of second source/drain regions 130b.

In some embodiments, an upper surface of the first portion 232a of each of the plurality of lower contacts 232 may contact lower surfaces of the insulation barriers 124 of the second group. In some embodiments, the second portion 232b of each of the plurality of lower contacts 232 may include a portion which extends to an inner portion of a corresponding second source/drain region 130b of the plurality of second source/drain regions 130b. In some embodiments, an upper surface of the second portion 232b may be disposed at a vertical level which is higher than a second vertical level LV2.

In some embodiments, the second portion 232b of each of the plurality of lower contacts 232 may be apart from a plurality of gate structures 162 with the insulation barriers 124 of the second group therebetween in the first horizontal direction (the X direction). For example, the plurality of lower contacts 232 may be apart from the plurality of gate structures 162 with the insulation barriers 124 of the second group therebetween, and thus, the electrical reliability of the integrated circuit device 100b may be secured.

In some embodiments, a seventh horizontal width wx31, which is a width of the first portion 232a in the first horizontal direction (the X direction), may be greater than an eighth horizontal width wx32, which is a width of the second portion 232b in the first horizontal direction (the X direction). In some embodiments, the seventh horizontal width wx31 of the first portion 232a may be the same as a first horizontal width wx1 of the plurality of insulation barriers 124 and may be the same as a second horizontal width wx2 of the plurality of insulation blocks 212. In some embodiments, the seventh horizontal width wx31 of the first portion 232a may be constant, regardless of a vertical level. In some embodiments, the eighth horizontal width wx32 of the second portion 232b may decrease progressively in a direction distancing from a first coplanar surface BSSB in the vertical direction (the Z direction).

FIGS. 5A and 5B are cross-sectional views for describing an integrated circuit device 100c according to some other embodiments. FIG. 5A is a cross-sectional view of a portion corresponding to a cross-sectional surface taken along line X1-X1' of FIG. 1, and FIG. 5B is an enlarged view of a region EX5 of FIG. 5A. In detail, the difference between the integrated circuit device 100c described above with reference to FIGS. 5A and 5B and the integrated circuit device 100b may be whether a lower insulation liner 230 is disposed between a first portion 232a of each of a plurality of lower contacts 232 and an adjacent gap-fill insulation layer 222. In FIGS. 5A and 5B, the same reference numerals as FIGS. 1, 2A to 2D, 4A, and 4B refer to like elements, and repeated descriptions thereof are omitted.

According to embodiments, the lower insulation liner 230 covering a sidewall of the first portion 232a of each of the plurality of lower contacts 232 may be disposed on a lower surface of each of a plurality of second group insulation barriers 124. According to embodiments, the lower insulation liner 230 may be disposed between the first portion 232a of each of the plurality of lower contacts 232 and adjacent gap-fill insulation layers 222. For example, the first portion 232a of each of the plurality of lower contacts 232 may be apart from the gap-fill insulation layer 222 in a first horizontal direction (an X direction) with the lower insulation liner 230 therebetween.

According to embodiments, the first portion 232a and a second portion 232b of each of the plurality of lower contacts 232 may overlap each other in a vertical direction (a Z direction). In some embodiments, a sidewall of the first portion 232a and a sidewall of the second portion 232b may configure a coplanar surface and extend. In some embodiments, the lower insulation liner 230 may vertically overlap the second group insulation barriers 124. For example, the first portion 232a may not vertically overlap the second group insulation barriers 124.

In some embodiments, a seventh horizontal width wx31 of the first portion 232a of each of the plurality of lower contacts 232 may be less than a first horizontal width wx1 of the plurality of insulation barriers 124 and may be less than a second horizontal width wx2 of a plurality of insulation blocks 212. In some embodiments, the seventh horizontal width wx31 of the first portion 232a may be constant, regardless of a vertical level. In some embodiments, the eighth horizontal width wx32 of the second portion 232b may decrease progressively in a direction distancing from a first coplanar surface BSSB in the vertical direction (the Z direction).

FIGS. 6A to 19B are cross-sectional views illustrating in a process sequence a method of manufacturing an integrated circuit device, according to embodiments, FIGS. 6A, 7A, 8A, 9A, 10A, 11A, 12, 13, 14A, 15A, 16A, 17A, 18A, and 19A are cross-sectional views illustrating in a process sequence a portion corresponding to a cross-sectional surface taken along line X1-X1' of FIG. 1, and FIGS. 6B, 7B, 8B, 9B, 10B, 11B, 14B, 15B, 16B, 17B, 18B, and 19B are cross-sectional views illustrating in a process sequence a cross-sectional surface taken along line Y1-Y1' of FIG. 1 and a cross-sectional surface taken along line Y2-Y2' of FIG. 1. In FIGS. 6A to 19B, the same reference numerals as FIGS. 1 and 2A to 2D refer to like elements, and repeated descriptions thereof are omitted.

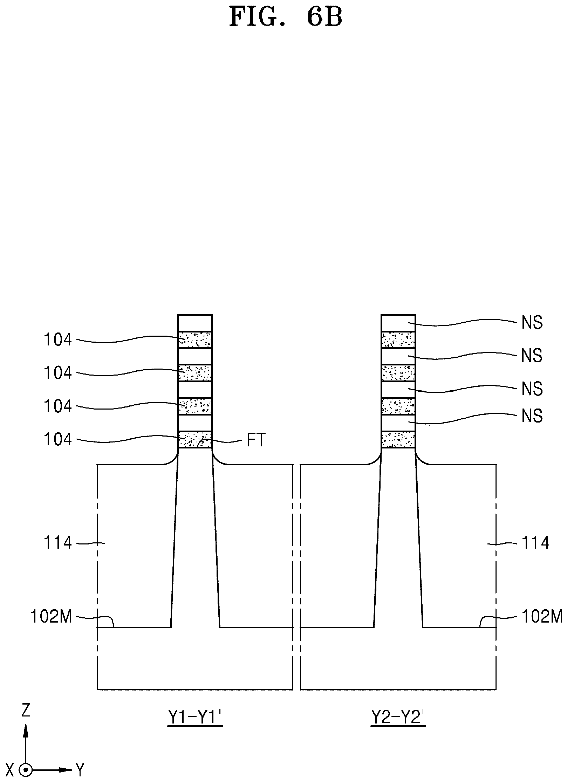

Referring to FIGS. 6A and 6B, a plurality of sacrificial semiconductor layers 104 and a plurality of nanosheet semiconductor layers NS may be alternately stacked on a substrate 102 one-by-one, and then, a plurality of fin-type structures FA may be defined on the substrate 102 by etching a portion of the substrate 102, the plurality of sacrificial semiconductor layers 104, and the plurality of nanosheet semiconductor layers NS. The plurality of fin-type structures FA may protrude in a vertical direction (a Z direction) from a main surface 102M of the substrate 102. Subsequently, a device isolation layer 114 covering a sidewall of each of the plurality of fin-type structures FA may be formed. A stack structure of the plurality of sacrificial semiconductor layers 104 and the plurality of nanosheet semiconductor layers NS may remain on a fin top FT of each of the plurality of fin-type structures FA.

In some embodiments, the substrate 102 may include a semiconductor, such as Si or Ge, or a compound semiconductor such as SiGe, SiC, GaAs, InAs, InGaAs, or InP. The terms "SiGe", "SiC", "GaAs", "InAs", "InGaAs", and "InP" used herein may each denote a material consisting of elements included in a corresponding term and may not be a chemical formula representing a stoichiometric relationship. For example, the substrate 102 may be a bulk Si substrate.

The plurality of sacrificial semiconductor layers 104 and the plurality of nanosheet semiconductor layers NS may respectively include semiconductor materials having different etch selectivity. In some embodiments, the plurality of nanosheet semiconductor layers NS may include a Si layer and the plurality of sacrificial semiconductor layers 104 may include a SiGe layer. In some embodiments, a Ge content ratio of the plurality of sacrificial semiconductor layers 104 may be constant. The SiGe layer configuring the plurality of sacrificial semiconductor layers 104 may have a constant Ge content ratio selected from within a range of about 5 at.% to about 60 at.% (for example, a range of about 10 at.% to about 40 at.%). A Ge content ratio of the SiGe layer configuring the plurality of sacrificial semiconductor layers 104 may be variously selected depending on the case.

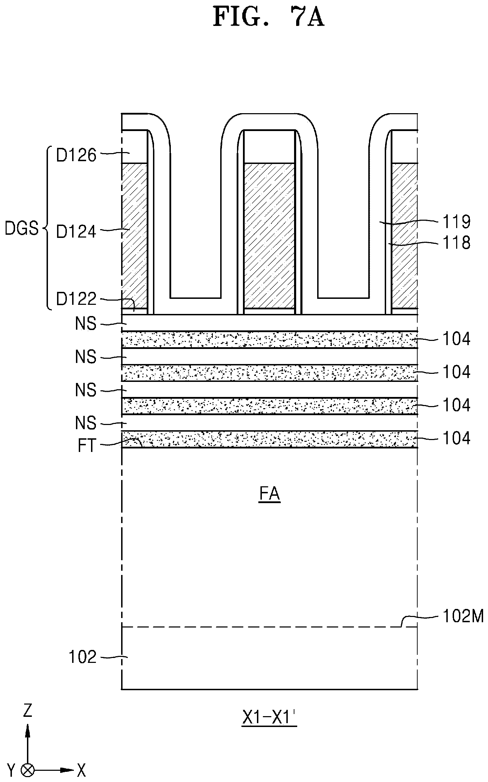

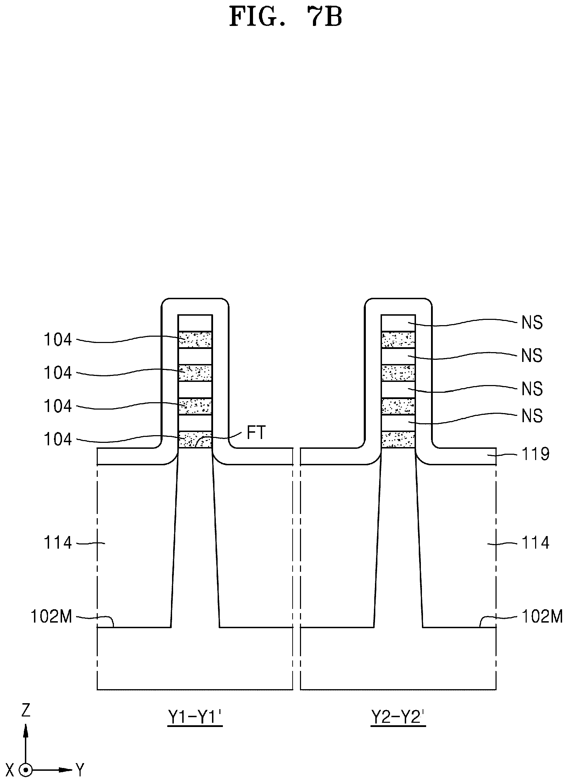

Referring to FIGS. 7A and 7B, a plurality of dummy gate structures DGS may be formed on a stack structure of the plurality of sacrificial semiconductor layers 104 and the plurality of nanosheet semiconductor layers NS. Each of the plurality of dummy gate structures DGS may extend long in a second horizontal direction (a Y direction). Each of the plurality of dummy gate structures DGS may have a structure where an oxide layer D122, a dummy gate layer D124, and a capping layer D126 are sequentially stacked. In some embodiments, the dummy gate layer D124 may include polysilicon, and the capping layer D126 may include silicon nitride.

Subsequently, an inner gate insulation spacer 118 covering both sidewalls of the dummy gate structure DGS may be formed, and then, a spacer 119 covering the fin-type structure FA, the dummy gate structure DGS, and the inner gate insulation spacer 118 may be formed. For example, the inner gate insulation spacer 118 may include SiN. For example, the spacer 119 may include SiOCN, SiCN, or a combination thereof. In some embodiments, the spacer 119 may include a single layer including SiOCN. In some other embodiments, the spacer 119 may include a SiOCN layer covering the inner gate insulation spacer 118 and an oxide layer covering the SiOCN layer.

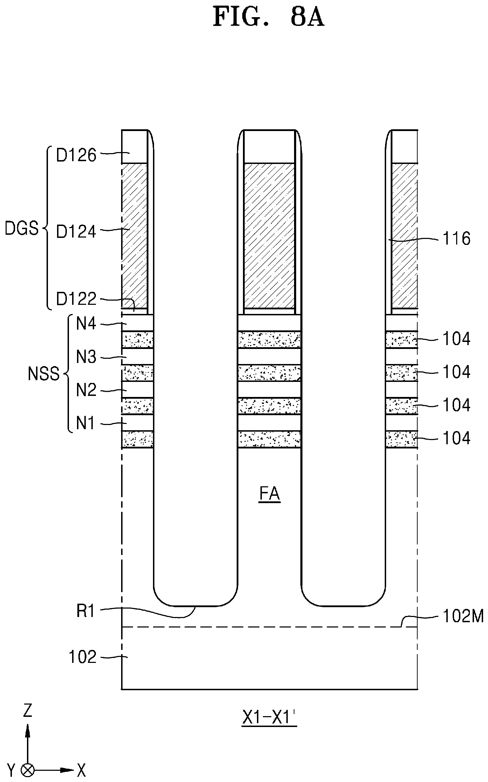

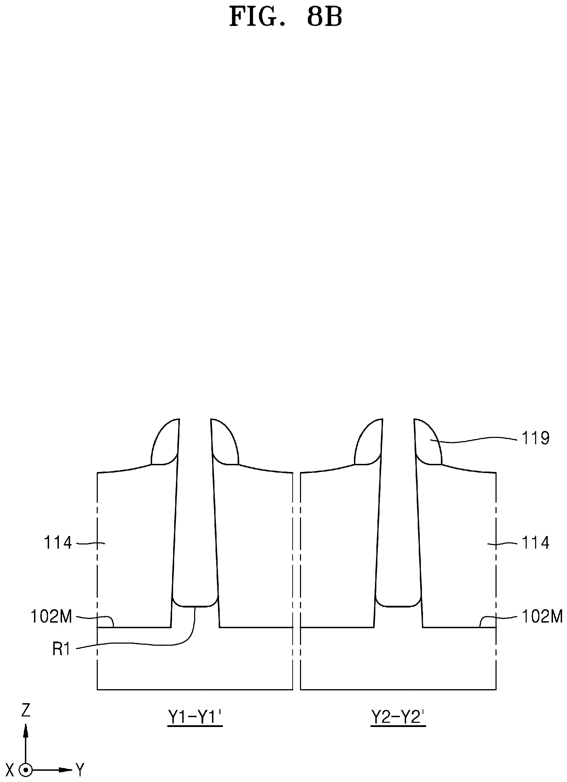

Referring to FIGS. 8A and 8B, by etching a portion of the spacer 119, an outer insulation spacer 116 covering both sidewalls of the dummy gate structure DGS may be formed from the inner gate insulation spacer 118 and the spacer 119. While forming the outer insulation spacer 116, as the spacer 119 is etched, a fin-type structure FA may be exposed. The fin-type structure FA exposed as described above may be etched along with the spacer 119, and thus, a first recess R1 may be formed on the fin-type structure FA. An etching process using a dry etching process, a wet etching process, or a combination thereof may be performed for forming the first recess R1. In some embodiments, a lower surface of the first recess R1 may be disposed at a vertical level which is lower than an upper surface of each of a plurality of device isolation layers 114 and may be disposed at a vertical level which is higher than the main surface 102M of the substrate 102.

While performing an etching process for forming the first recess R1, a first recess-side insulation spacer 119 covering both sidewalls of the fin-type structure FA may be formed in a region adjacent to the first recess R1.

After the first recess R1 is formed in the fin-type structure FA, a plurality of nanosheet semiconductor layers NS (see FIGS. 7A and 7B) may be divided into a plurality of nanosheet stacks NSS. Each of the plurality of nanosheet stacks NSS may include a first nanosheet N1, a second nanosheet N2, a third nanosheet N3, and a fourth nanosheet N4.

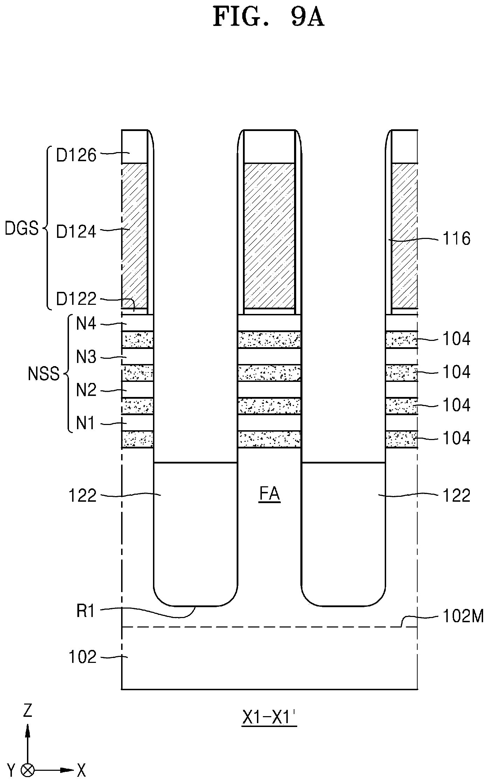

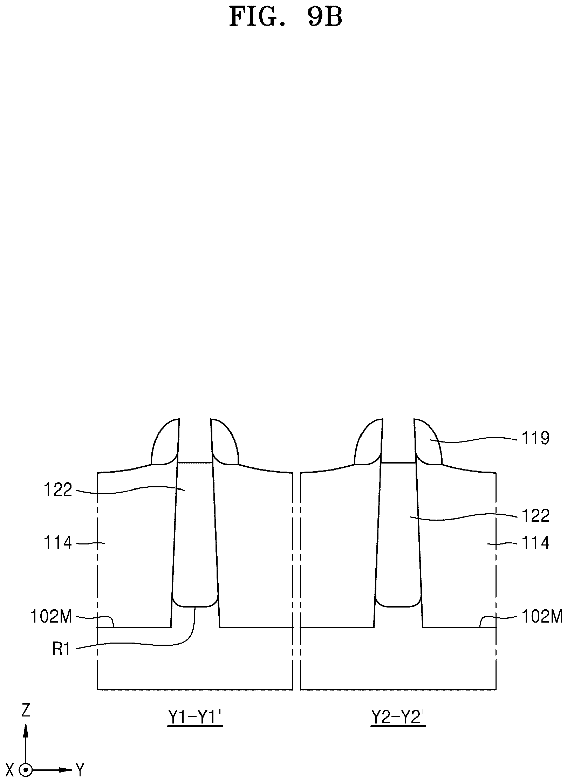

Referring to FIGS. 9A and 9B, in a resultant material of FIGS. 8A and 8B, a plurality of sacrificial semiconductor blocks 122 filling a portion of the first recess R1 may be formed. The plurality of sacrificial semiconductor blocks 122 may be formed by selectively epitaxial-growing a semiconductor material from the fin-type structure FA exposed through the first recess R1. In some embodiments, the plurality of sacrificial semiconductor blocks 122 may include an epitaxial-grown Si layer, an epitaxial-grown SiC layer, or an epitaxial-grown SiGe layer.

In some embodiments, an upper surface of each of the plurality of sacrificial semiconductor blocks 122 may be disposed at a vertical level which is lower than a lower surface of a lowermost sacrificial semiconductor layer 104 of the plurality of sacrificial semiconductor layers 104 stacked in the vertical direction (the Z direction). In some embodiments, a top profile of each of the plurality of sacrificial semiconductor blocks 122 may be formed to be flat by adjusting an epitaxial growth temperature.

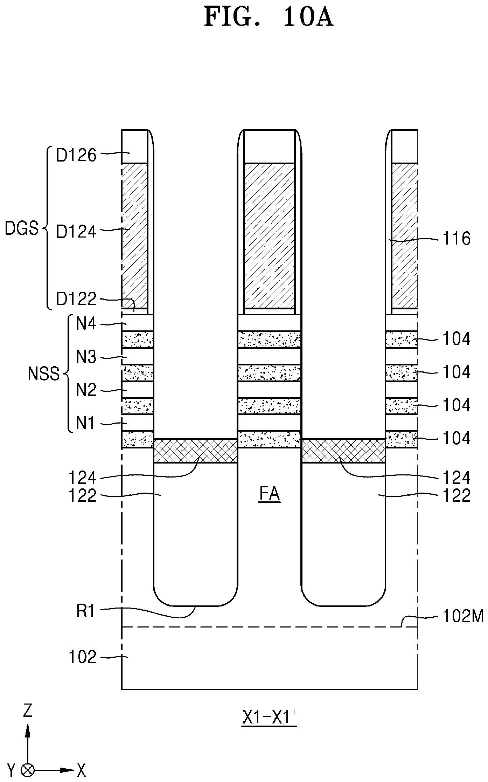

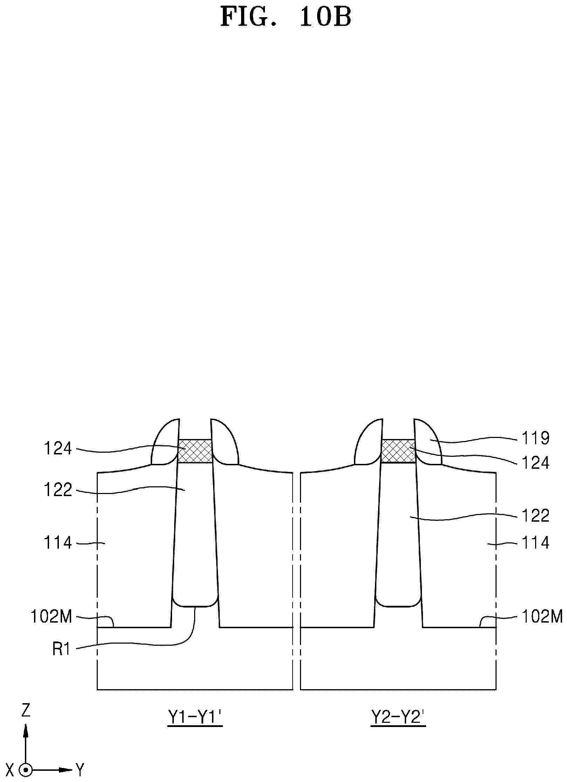

Referring to FIGS. 10A and 10B, in a resultant material of FIGS. 9A and 9B, a plurality of insulation barriers 124 filling a portion of the first recess R1 may be respectively formed on the plurality of sacrificial semiconductor blocks 122. In some embodiments, a vertical level of an upper surface of each of the plurality of insulation barriers 124 may be disposed at a vertical level which is higher than the lower surface of the lowermost sacrificial semiconductor layer 104 of the plurality of sacrificial semiconductor layers 104 stacked in the vertical direction (the Z direction).

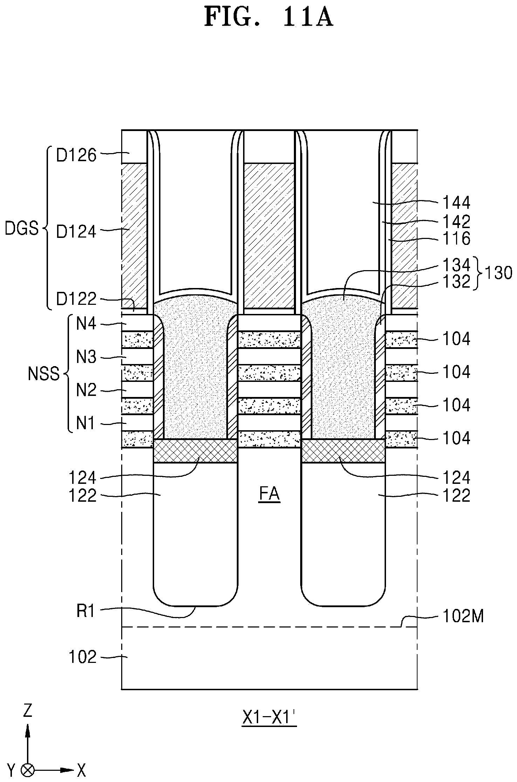

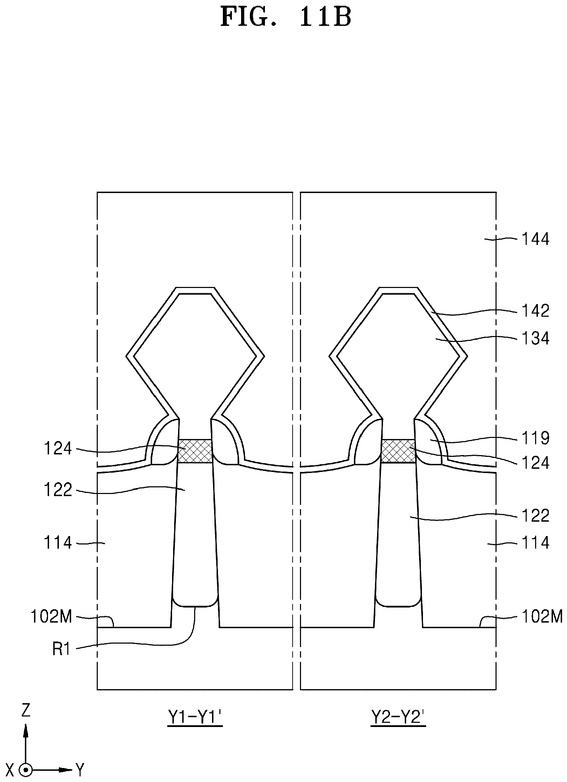

Referring to FIGS. 11A and 11B, in a resultant material of FIGS. 10A and 10B, a plurality of source/drain regions 130 may be formed by selectively epitaxial-growing a semiconductor material in the first recess R1. For example, a source/drain barrier 132 and a source/drain body 134 may be sequentially formed in the first recess R1.

In some embodiments, a semiconductor material may be epitaxial-grown from a sidewall of each of the plurality of sacrificial semiconductor layers 104 and a sidewall of each of the plurality of nanosheets N1 to N4 exposed through the first recess R1, so as to form the source/drain barrier 132. In some embodiments, the source/drain barrier 132 may cover the sidewall of each of the plurality of sacrificial semiconductor layers 104 and the sidewall of each of the plurality of nanosheets N1 to N4. For example, a portion adjacent to the sidewall of each of the plurality of sacrificial semiconductor layers 104 and the sidewall of each of the plurality of nanosheets N1 to N4 may be a portion of an upper surface of each of the plurality of insulation barriers 124 and may be covered by the source/drain barrier 132, and the other portion of the upper surface may be exposed.

In some embodiments, a low-pressure chemical vapor deposition (LPCVD) process, a selective epitaxial growth (SEG) process, or a cyclic deposition and etching (CDE) process may be performed by using source materials including an element semiconductor precursor, so as to form the source/drain barrier 132. The element semiconductor precursor may include an element such as Si or Ge.

For example, a Si source and a Ge source may be used for forming the source/drain barrier 132. The Si source may use silane (SiH₄), disilane (Si₂H₆), trisilane (Si₃H₈), dichlorosilane (SiH₂Cl₂), but is not limited thereto. The Ge source may use germane (GeH₄), digermane (Ge₂H₆), trigermane (Ge₃H₈), tetragermane (Ge₄H₁₀), dichlorogermane (Ge₂H₂Cl₂), but is not limited thereto. When the source/drain barrier 132 includes a SiGe layer doped with boron (B), a B source as well as the Si source and the Ge source may be further used for forming the B-doped SiGe layer. The B source may use diborane (B₂H₆), triborane, tetraborane, and pentaborane, but is not limited thereto. In some embodiments, a B dopant ion injection process using the B source may be performed through in-situ when performing an epitaxial growth process for forming the source/drain barrier 132.

In some embodiments, a portion, which is not covered by the source/drain barrier 132, of an upper surface of each of the plurality of insulation barriers 124 and the source/drain body 134 covering the source/drain barrier 132 may be formed on the plurality of insulation barriers 124. A process similar to the description of a process of forming the source/drain barrier 132 may be performed for forming the source/drain body 134. In some embodiments, a process of forming the source/drain body 134 may be performed through in-situ and a process of forming the source/drain barrier 132.

Subsequently, an insulation liner 142 covering the plurality of source/drain regions 130 may be formed and an inter-gate insulation layer 144 may be formed on the insulation liner 142, and then, an upper surface of the capping layer D126 may be exposed by planarizing the insulation liner 142 and the inter-gate insulation layer 144.

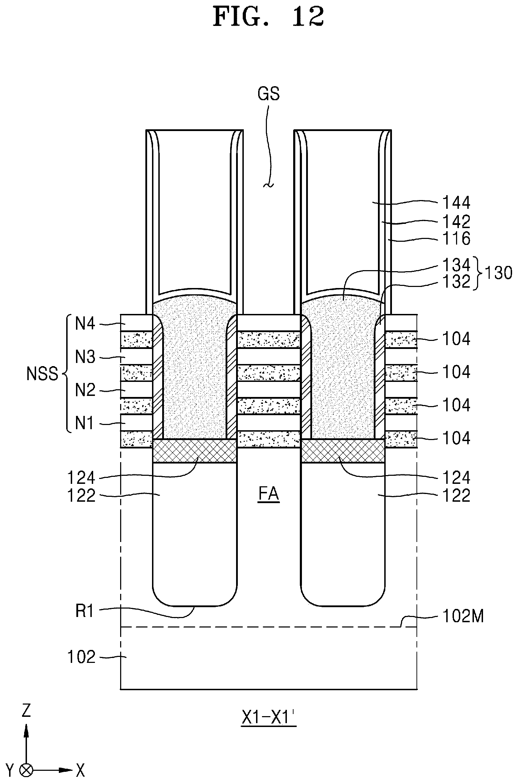

Referring to FIG. 12, an upper surface of the dummy gate layer D124 may be exposed by removing the capping layer D126 from a resultant material of FIGS. 11A and 11B, and a portion of each of the insulation liner 142 and the inter-gate insulation layer 144 may be removed so that the upper surface of the inter-gate insulation layer 144 and the upper surface of the dummy gate layer D124 are disposed at approximately the same level.

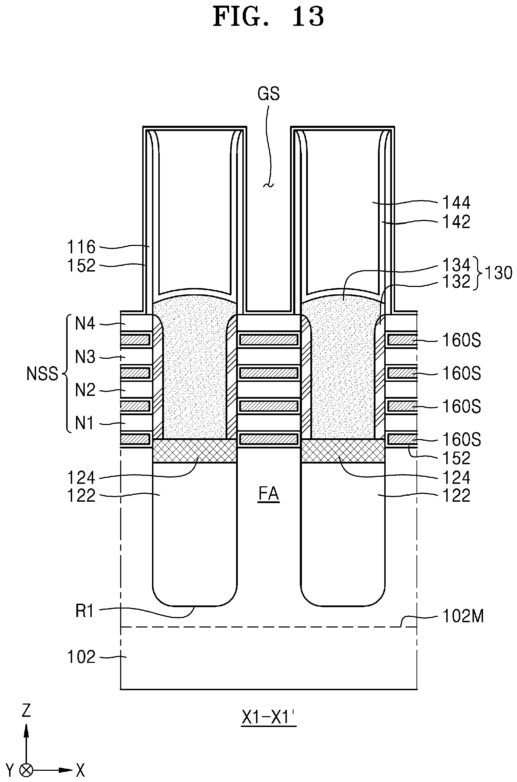

Referring to FIG. 13, a gate space GS may be provided by removing the dummy gate layer D124 and the oxide layer D122 thereunder from a resultant material of FIG. 12, and the plurality of nanosheet stacks NSS may be exposed through the gate space GS. Subsequently, as the plurality of sacrificial semiconductor layers 104 remaining on the fin-type structure FA are removed through the gate space GS, the gate space GS may enlarge up to a space between the first nanosheet N1 and a fin top FT of the fin-type structure FA and between the first nanosheet N1, the second nanosheet N2, the third nanosheet N3, and the fourth nanosheet N4.

In some embodiments, an etch selectivity difference between the plurality of sacrificial semiconductor layers 104 and the first to fourth nanosheets N1 to N4 may be used for selectively removing the plurality of sacrificial semiconductor layers 104. A liquid or gaseous etchant may be used for selectively removing the plurality of sacrificial semiconductor layers 104. In some embodiments, a CH₃COOH-based etchant (for example, an etchant consisting of a compound of CH₃COOH, HNO₃, and HF, or an etchant consisting of a compound of CH₃COOH, H₂O₂, and HF) may be used for selectively removing the plurality of sacrificial semiconductor layers 104, but inventive concepts are not limited thereto.

Subsequently, a gate dielectric layer 152 covering exposed surfaces of the first nanosheet N1, the second nanosheet N2, the third nanosheet N3, the fourth nanosheet N4, and the fin-type structure FA may be formed. An atomic layer deposition (ALD) process may be used for forming the gate dielectric layer 152.

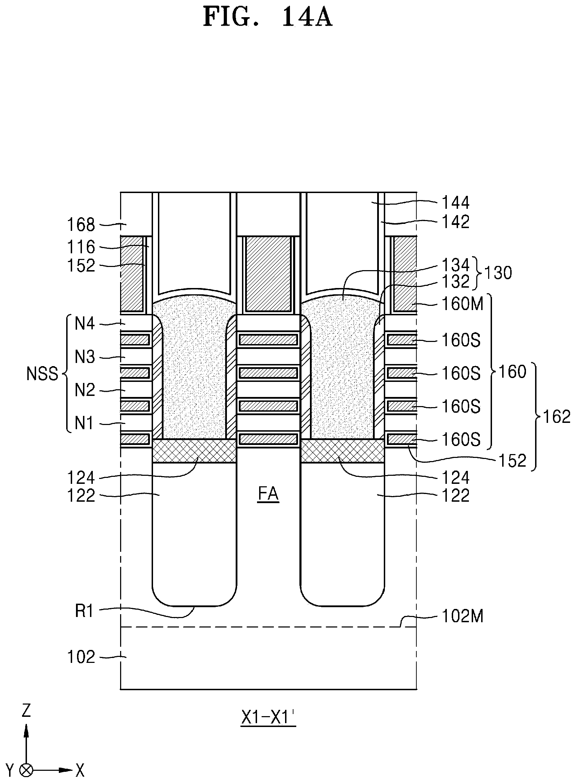

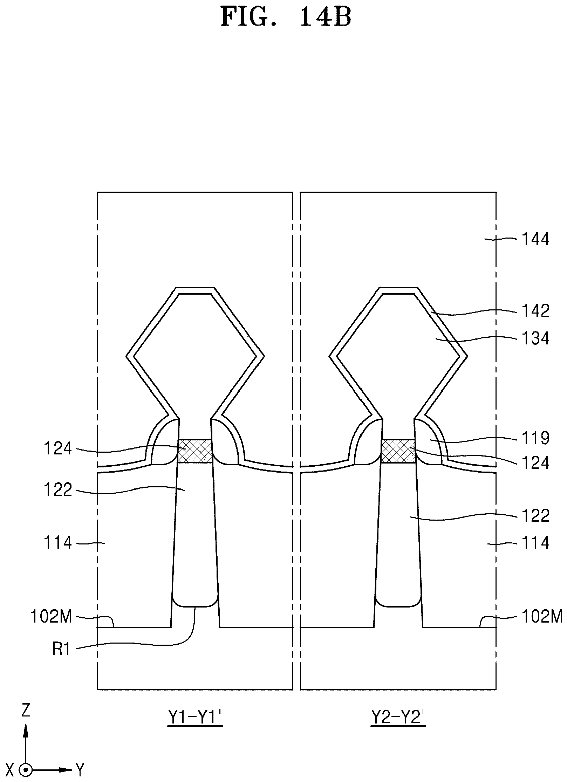

Referring to FIGS. 14A and 14B, a gate formation conductive layer (not shown) covering the upper surface of the inter-gate insulation layer 144 may be formed on the gate dielectric layer 152 to fill the gate space GS (see FIG. 13). The gate formation conductive layer (not shown) may include metal, metal nitride, metal carbide, or a combination thereof. An ALD process or a CVD process may be used for forming the gate formation conductive layer (not shown). Subsequently, the gate structure 162 may be formed by removing a portion of an upper surface of each of the gate formation conductive layer (not shown), the gate dielectric layer 152, and the outer insulation spacer 116 so that an upper surface of the inter-gate insulation layer 144 is exposed and a portion of an upper portion of the gate space GS is again emptied. Subsequently, a capping insulation pattern 168 filling the gate space GS may be formed on the gate structure 162.

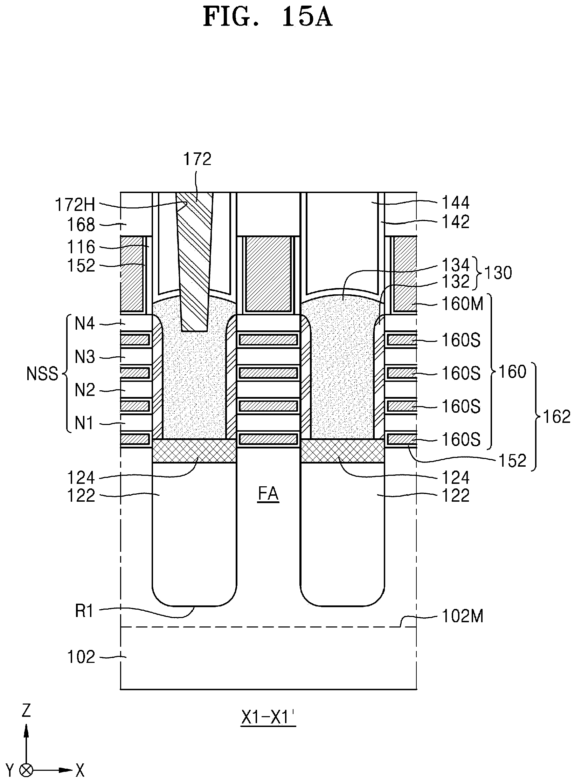

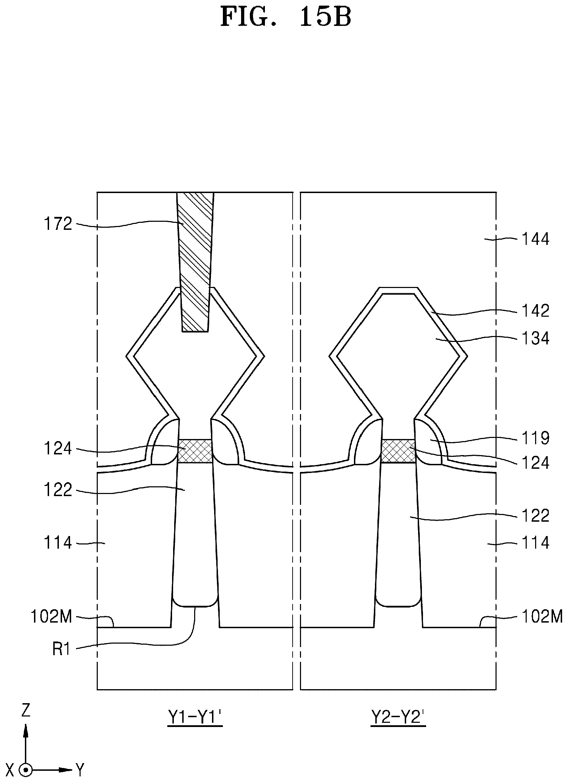

Referring to FIGS. 15A and 15B, in a resultant material of FIGS. 14A and 14B, a plurality of upper contact holes 172H exposing a plurality of first source/drain regions 130a may be formed by removing a portion of the insulation liner 142 and a portion of the inter-gate insulation layer 144, and then, the plurality of upper contact holes 172H may extend long toward the substrate 102 by removing a partial region of each of the plurality of first source/drain regions 130a through the plurality of upper contact holes 172H by using an anisotropic etching process. Subsequently, a metal silicide layer (not shown) may be formed on the plurality of first source/drain regions 130a exposed at bottoms of the plurality of upper contact holes 172H. In embodiments, a process of forming a metal liner (not shown) conformally covering exposed surfaces of the plurality of first source/drain regions 130a and inducing a reaction with metal included in the metal liner and the plurality of first source/drain regions 130a through thermal treatment may be performed for forming the metal silicide layer (not shown). Subsequently, a plurality of upper contacts 172 may be formed on the metal silicide layer. Subsequently, a plurality of front-side wiring layers (not shown) covering the upper surface of the inter-gate insulation layer 144 and upper surfaces of the plurality of upper contacts 172 and a plurality of capping insulation patterns 168 may be formed, and thus, the front-side structure FSS of FIG. 1 may be formed.

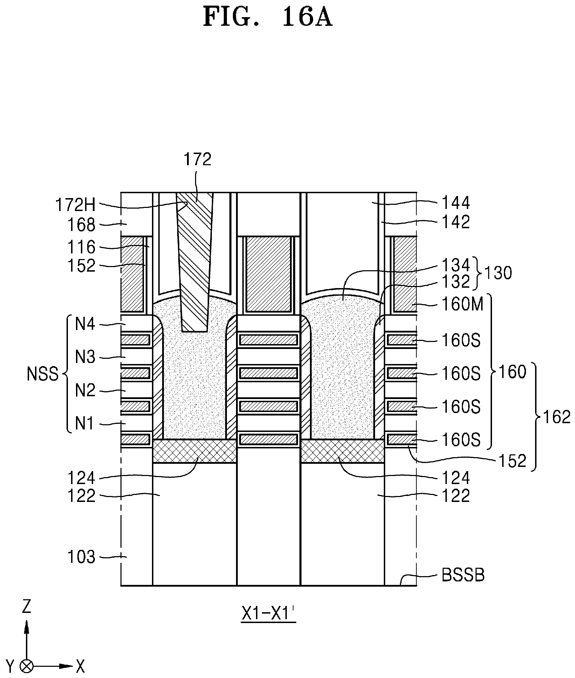

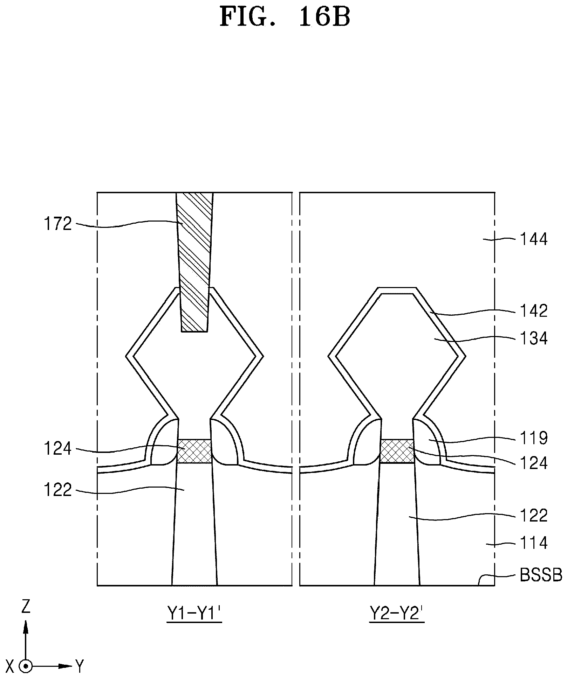

Referring to FIGS. 16A and 16B, a carrier substrate (not shown) may be attached on the front-side structure FSS, and then, a backside surface of the substrate 102 may be polished so that the plurality of sacrificial semiconductor blocks 122 are exposed. In such a process, a portion of each of the plurality of device isolation layers 114, a portion of the substrate 102, and a portion of each of the plurality of sacrificial semiconductor blocks 122 may be removed. For example, the plurality of sacrificial semiconductor blocks 122 may each be used as an etch stop layer, and the plurality of source/drain regions 130 may be self-aligned through the exposed plurality of sacrificial semiconductor blocks 122.

In some embodiments, the substrate 102 disposed at a vertical level which is lower than the first recess R1 illustrated in FIGS. 16A and 16B may be removed in a polishing process, and thus, a plurality of backside trenches BT defining a boundary of the fin-type structure FA may be formed. For example, the plurality of backside trenches BT may extend in parallel in the first horizontal direction (the X direction), and the plurality of sacrificial semiconductor blocks 122 and a plurality of residual blocks 103 which are a portion, remaining without being removed, of the substrate 102 may be disposed in the plurality of backside trenches BT.

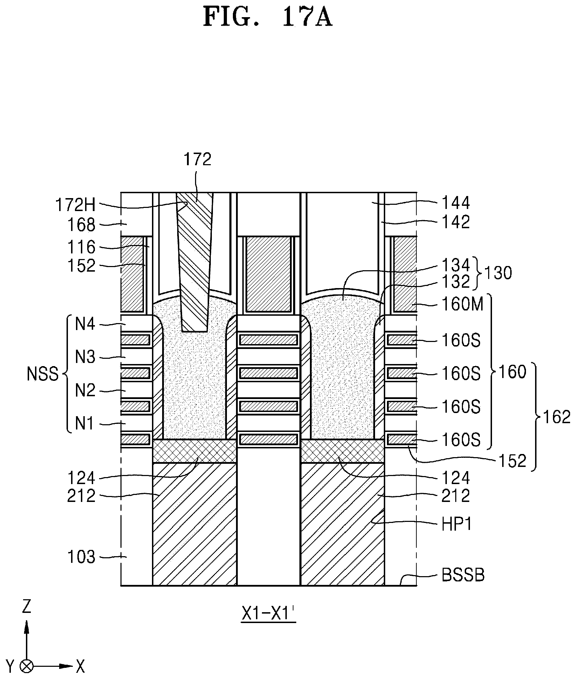

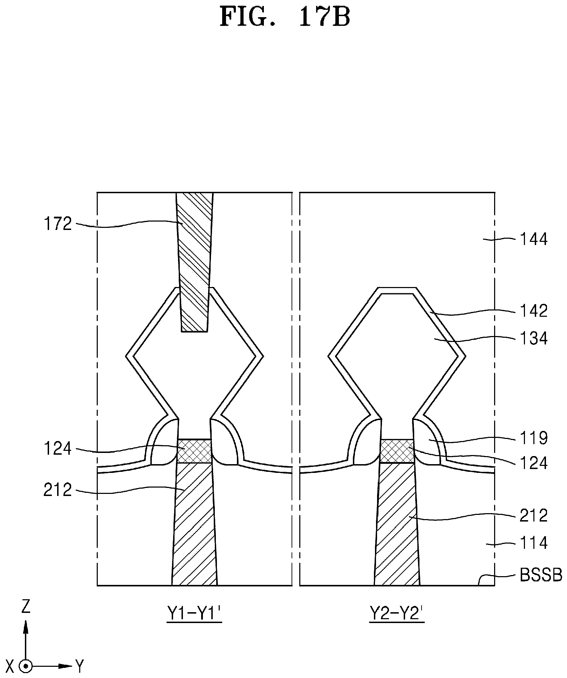

Referring to FIGS. 17A and 17B, in a resultant material of FIGS. 16A and 16B, a first hole pattern HP1 may be formed by removing the plurality of sacrificial semiconductor blocks 122 exposed through a backside surface. For example, the plurality of sacrificial semiconductor blocks 122 may be removed by dry etching or wet etching, but the embodiments are not limited thereto. For example, the first hole pattern HP1 may be defined by the plurality of residual blocks 103, the plurality of device isolation layers 114, and the plurality of insulation barriers 124.

Subsequently, the plurality of insulation blocks 212 filling the first hole pattern HP1 may be formed. For example, the plurality of insulation blocks 212 may be formed by polishing a backside surface until the plurality of residual blocks 103 are exposed after a spin coating layer filling the first hole pattern HP1 is formed.

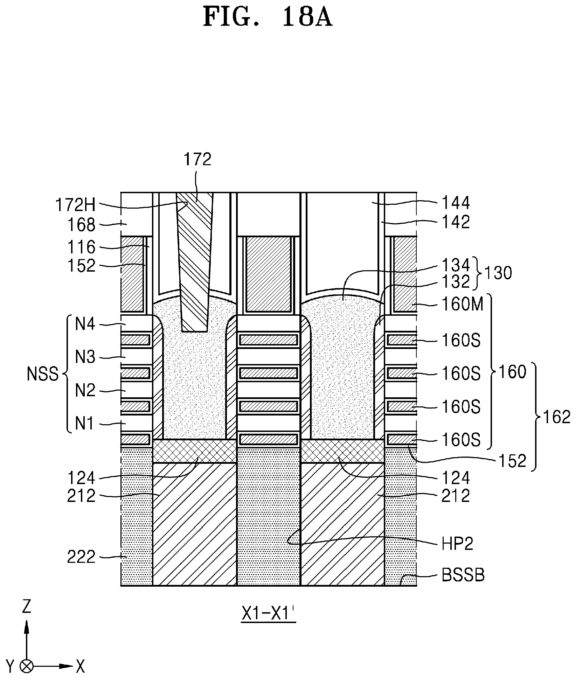

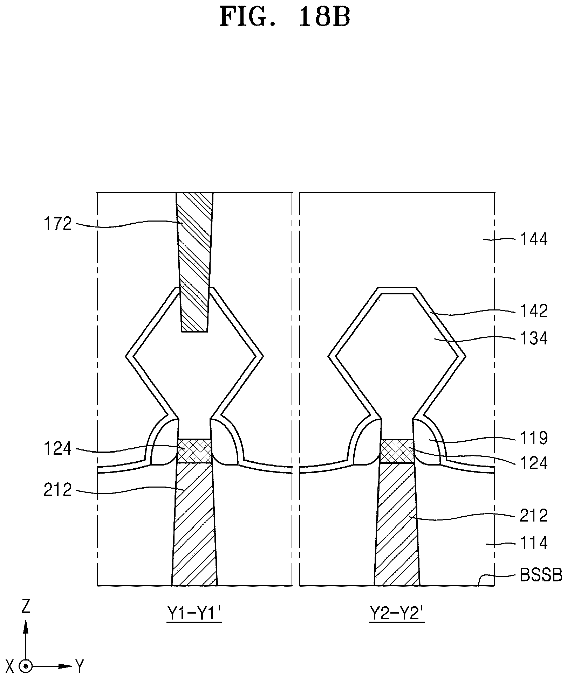

Referring to FIGS. 18A and 18B, in a resultant material of FIGS. 17A and 17B, a second hole pattern HP2 may be formed by removing the plurality of residual blocks 103 exposed through the backside surface. In some embodiments, the plurality of residual blocks 103 may be removed by wet etching, and thus, may be easily removed up to a residual block 103 of a corner portion of the second hole pattern HP2 while limiting and/or preventing the damage of the plurality of gate structures 162.

In some embodiments, the second hole pattern HP2 may be defined by the plurality of insulation blocks 212, the plurality of device isolation layers 114, the plurality of insulation barriers 124, and the plurality of gate structures 162. In some embodiments, the second hole pattern HP2 may wholly expose lower surfaces of the plurality of gate structures 162. For example, a width of the second hole pattern HP2 in the first horizontal direction (the X direction) may be equal to a sum of a width of the lowermost sub gate portion 160S and a width of the gate dielectric layer 152 covering both sidewalls of the lowermost sub gate portion 160S in the first horizontal direction (the X direction). Even in this case, lower portions of the plurality of source/drain regions 130 may be protected by the insulation barrier 124, and thus, may be limited and/or prevented from being damaged by etching. Therefore, a portion of each of a plurality of residual blocks 103 adjacent to the lower portions of the plurality of source/drain regions 130 may not remain, so as to prevent that the lower portions of the plurality of source/drain regions 130 are exposed and removed along with the residual block 103. Also, the occurrence of power loss in the integrated circuit device due to a portion of a remaining residual block 103 may be prevented.

Subsequently, the plurality of gap-fill insulation layers 222 filling the second hole pattern HP2 may be formed. For example, the plurality of gap-fill insulation layers 222 may be formed by polishing a backside surface until the plurality of residual blocks 103 are exposed after a spin coating layer filling the second hole pattern HP2 is formed.

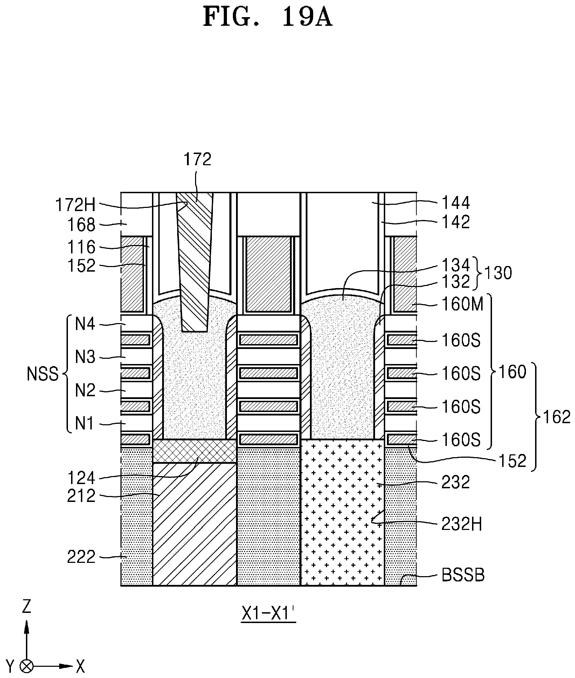

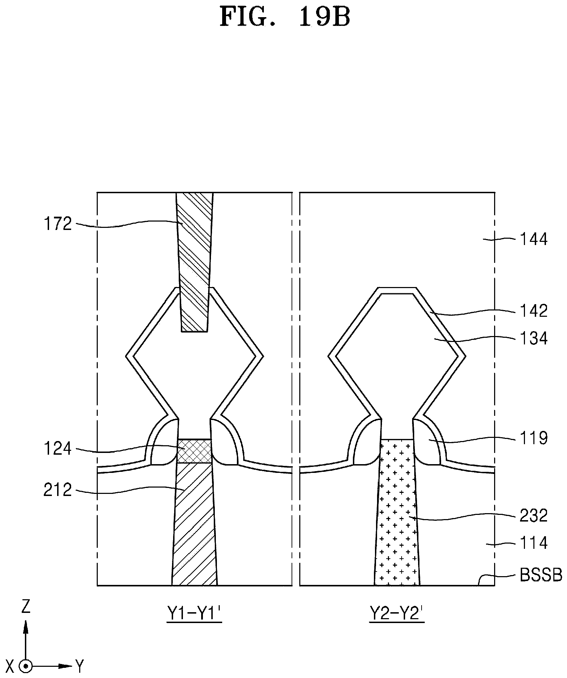

Referring to FIGS. 19A and 19B, in a resultant material of FIGS. 18A and 18B, an etch mask (not shown) exposing insulation blocks 212 vertically overlapping the plurality of second source/drain regions 130b may be formed on the backside surface, and then, a lower contact hole 232H exposing a lower surface of the second source/drain region 130b may be formed by removing the insulation barriers 124 and the insulation blocks 212 under the plurality of second source/drain regions 130b. In some embodiments, the plurality of gap-fill insulation layers 222 may have an etch selectivity with respect to the plurality of insulation barriers 124 and the plurality of insulation blocks 212. In some embodiments, the source/drain barrier 132 and the source/drain body 134 of the plurality of second source/drain regions 130b may be exposed through the lower contact hole 232H. Subsequently, a conductive material may be filled into the lower contact hole 232H, and then, the plurality of lower contacts 232 may be formed by polishing the backside surface. Therefore, lower surfaces of the plurality of lower contacts 232, lower surfaces of the plurality of gap-fill insulation layers 222, lower surfaces of the plurality of insulation blocks 212, and lower surfaces of the plurality of device isolation layers 114 may configure a first coplanar surface BSSB.

Referring to FIGS. 2A to 2D, in a resultant material of FIGS. 19A and 19B, an insulation material layer (not shown) may be formed on the first coplanar surface BSSB, and then, a metal power rail 254 and a lower insulation layer 252 may be formed by filling a conductive material into a hole pattern (not shown) which is formed by removing a portion of the insulation material layer.

Hereinabove, a method of manufacturing the integrated circuit device 100 illustrated in FIGS. 1 and 2A to 2D has been described above with reference to FIGS. 6A to 19B, but it may be seen by those of ordinary skill in the art that the integrated circuit devices illustrated in FIGS. 3A to 5B and integrated circuit devices having various structures implemented by modifying and changing the integrated circuit devices may be manufactured through various modifications and changes within the scope of inventive concepts.

While inventive concepts have been particularly shown and described with reference to embodiments thereof, it will be understood that various changes in form and details may be made therein without departing from the scope of the following claims.

## Claims

1. An integrated circuit device comprising:
a plurality of device isolation layers (114) extending lengthwise in a first horizontal direction (X), the plurality of device isolation layers arranged apart from one another in a second horizontal direction, the second horizontal direction being perpendicular to the first horizontal direction;
a plurality of gap-fill insulation layers (222) arranged apart from one another in the first horizontal direction between adjacent device isolation layers among the plurality of device isolation layers (114);
a plurality of gate structures (162) arranged apart from one another in the first horizontal direction (162), the plurality of gate structures (162) on the plurality of gap-fill insulation layers (222) and extending lengthwise in the second horizontal direction (Y);
a first source/drain region (130a) and a second source/drain region (130b) respectively disposed at both sides of a first gate structure among the plurality of gate structures (162) with respect to the first horizontal direction (X);
an insulation block (212) under the first source/drain region (130a);
an insulation barrier (124) between the first source/drain region (130a) and the insulation block (212), the insulation barrier (124) covering a lower surface of the first source/drain region (130a); and
a lower contact (232) apart from the insulation block (212) in the first horizontal direction (X) with a first gap-fill insulation layer among the plurality of gap-fill insulation layers (222) therebetween, the lower contact (232) contacting a lower surface of the second source/drain region (130b), and the lower contact (232) being under the second source/drain region (130b).

2. The integrated circuit device of claim 1, wherein the first source/drain region (130a) is apart from the first gap-fill insulation layer with the first insulation barrier (124) therebetween.

3. The integrated circuit device of claim 1 or 2, wherein one sidewall of the first insulation barrier (124) in the first horizontal direction (X) comprises a portion contacting the first gate structure (162).

4. The integrated circuit device of any one of claims 1 to 3, wherein at a same vertical level, a width of the insulation block (212) in the first horizontal direction (X) is equal to a width of the lower contact (232) in the first horizontal direction (X).

5. The integrated circuit device of any one of claims 1 to 4, wherein the first gap-fill insulation layer entirely covers a lower surface of the first gate structure.

6. The integrated circuit device of any one of claims 1 to 5, further comprising:
a nanosheet structure (NSS) apart from an upper surface of the first gap-fill insulation layer in a vertical direction (Z) and facing the upper surface of the first gap-fill insulation layer, wherein
the first gate structure surrounds the nanosheet structure (NSS) on the first gap-fill insulation layer, and
the nanosheet structure (NSS) includes a nanosheet or a plurality of nanosheets spaced apart from each other in the vertical direction.

7. The integrated circuit device of claim 6, wherein
the first source/drain region (130a) comprises a source/drain barrier (132) and a source/drain body (134),
the source/drain barrier (132) covers a side surface of the nanosheet structure (NSS) and a portion of a side surface of the first gate structure (130a),
the source/drain body (134) faces the first gate structure in the first horizontal direction with the source/drain barrier (132) therebetween, and
a lower surface of the source/drain body (134) contacts the first insulation barrier (124).

8. The integrated circuit device of any one of claims 1 to 7, wherein
lower surfaces of the device isolation layers (114), lower surfaces of the plurality of gap-fill insulation layers (222) , a lower surface of the insulation block (212), and a lower surface of the lower contact (232) provide a first coplanar surface.

9. The integrated circuit device of claim 8, further comprising:
a backside power rail (254) on the first coplanar surface, wherein
the backside power rail (254) contacts the lower contact (232).

10. The integrated circuit device of any one of claims 1 to 9, wherein
a vertical level of an upper surface of the first insulation barrier (124) is equal to a vertical level of an upper surface of the lower contact (232).

11. The integrated circuit device of claim 1,
the plurality of device isolation layers (114) defining sidewalls of a backside trench (BT) extending lengthwise in the first horizontal direction (X) between adjacent device isolation layers among the plurality of device isolation layers (114),
the plurality of gap-fill insulation layers (222) being in the backside trench (BT),
the integrated circuit device comprising a plurality of insulation barriers (124) in the backside trench (BT) and respectively disposed between adjacent gap-fill insulation layers of the plurality of gap-fill insulation layers (222),
the first insulation barrier being one of the plurality of insulation barriers (124);
the second source/drain region (130b) being on a second insulation barrier of the plurality of insulation barriers (124), and
the lower contact passing through the second insulation barrier and contacting the second source/drain region (130b).

12. The integrated circuit device of claim 11, further comprising:
a second insulation block (212) facing a lower surface of the second source/drain region (130b) in the vertical direction with the second insulation barrier (124) therebetween,
wherein the lower contact (232) passes through the second insulation block (212) and the second insulation barrier (124) and contacts the second source/drain region (130b).

13. The integrated circuit device of claim 11 or 12, wherein
a first portion of the lower contact (232) is in the backside trench and faces the first gap-fill insulation layer in the first horizontal direction,
the first portion (232a) of the lower contact (232) contacts a lower surface of the second insulation barrier (124),
a second portion (232b) of the lower contact (232)protrudes in the vertical direction from an upper surface of the first portion (232a) and passes through the second insulation barrier (124), and
the second portion (232b) of the lower contact (232) contacts the second source/drain region (130b).

14. The integrated circuit device of claim 11 or 12, further comprising:
an insulation liner between the lower contact (232) and the first gap-fill insulation layer (222), wherein
a first portion (232a) of the lower contact (232) faces the first gap-fill insulation layer (222) in the first horizontal direction with the insulation liner (230) therebetween,
the first portion (232a) of the lower contact (232) is in the backside trench (BT),
a second portion (232b) of the lower contact (232) extends in the vertical direction from the first portion (232a), and
the second portion (232b) of the lower contact (232) passes through the second insulation barrier (124) and contacts the second source/drain region (130b).

15. The integrated circuit device of any one of claims 1 to 14, wherein
a lower surface of the first gate structure is at a first vertical level,
an upper surface (124U) of at least one of the plurality of insulation barriers (124) is at a second vertical level (LV2), and
the second vertical level (LV2) is higher than the first vertical level (LV1).
